# EUROPEAN PATENT APPLICATION

(11) **EP 2 515 345 A1**
(43) Date of publication of application: **24.10.2012**
(21) Application number: 10837495.0
(22) Date of filing: 09.12.2010
(51) Int. Cl.: H01L 31/04, H01L 21/22, H01L 21/225, H01L 21/288, H01L 21/306

(54) **METHOD FOR MANUFACTURING SEMICONDUCTOR DEVICE AND BACK JUNCTION SOLAR CELL**

(30) Priority: 18.12.2009 JP 2009287155
(71) Applicant: Toray Industries, Inc., Tokyo 103-8666 (JP)
(72) Inventor: FUJIMORI, Shigeo, Otsu-shi Shiga 520-8558 (JP); KITAMURA, Yoshiyuki, Otsu-shi Shiga 520-8558 (JP); ANDO, Takashi, Otsu-shi Shiga 520-8558 (JP); GOTO, Tetsuya, Otsu-shi Shiga 520-8558 (JP)
(74) Representative: Hoefer & Partner
(86) International application number: PCT/JP2010/072100
(87) International publication number: WO 2011/074467

(57) **Abstract**

The present invention is to provide a manufacturing method capable of reducing costs of back-contact solar cell by realizing high-precision pattern application with a smaller process number. Specifically, it is a method for manufacturing a semiconductor device, being characterized in that a p-type region and/or n-type pattern is formed on a surface of a semiconductor substrate, including a step of ejecting at least one of etching paste, masking paste, doping paste, and electrode paste from an ejecting orifice of a nozzle toward the surface of the semiconductor substrate to form beads formed of the paste between the semiconductor substrate and the ejecting orifice and of moving the semiconductor substrate relative to the nozzle thereby the paste is applied to the surface of the semiconductor substrate in a stripe shape.

## Description

### Technical Field

The present invention relates to a method for manufacturing a semiconductor device and to a back-contact solar cell. In particular, the present invention relates to a suitable method for forming a stripe-shaped n-type or p-type doped region in a back-contact solar cell with high precision at low cost.

### Background Art

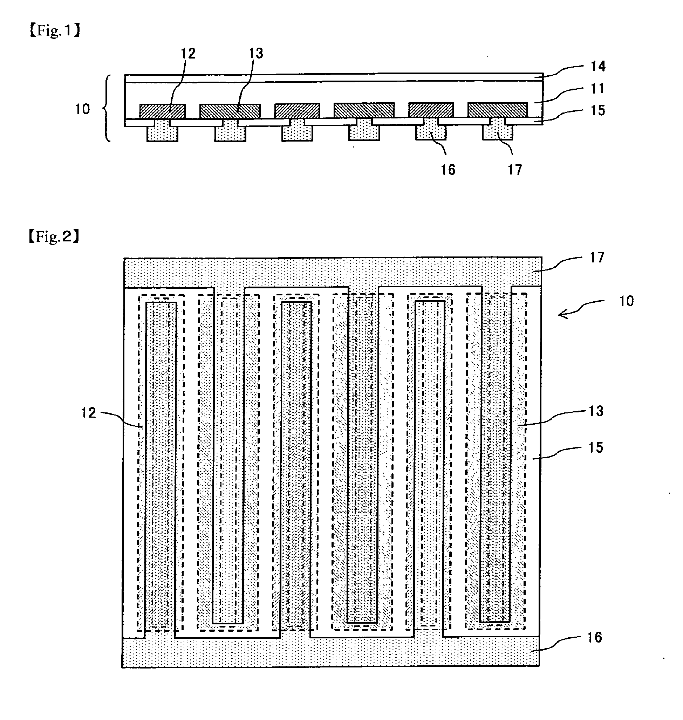

A back-contact solar cell having no electrode on a light receiving side thereof can in principle expect high conversion efficiency and also features excellent architectural designs viewed from the light receiving side, and its practical use has already started. Fig. 1 shows a typical sectional structure of the back-contact solar cell and Fig. 2 shows a planar structure thereof viewed from a back side.

In a back-contact solar cell 10 shown in Figs. 1 and 2, for example, a semiconductor substrate 11 including single crystalline n-type silicon has an n-type region 12 (high carrier concentration compared with the substrate) and a p-type region 13 formed repeatedly in a stripe shape on the back side (opposite side to the light receiving side). On the side on which these regions are formed, a passivation layer 15 having an opening for contact of each region with an electrode is formed and further an electrode 16 for contact with an n-type region and an electrode 17 for contact with a p-type region are similarly formed repeatedly in a stripe shape. A passivation layer 14 is formed on a roughly entire surface of the light receiving side of the semiconductor substrate 11. A textured structure or an antireflection layer to reduce light reflection losses may be formed on the light receiving side. P-type silicon or elements other than silicon may be used as the semiconductor substrate 11.

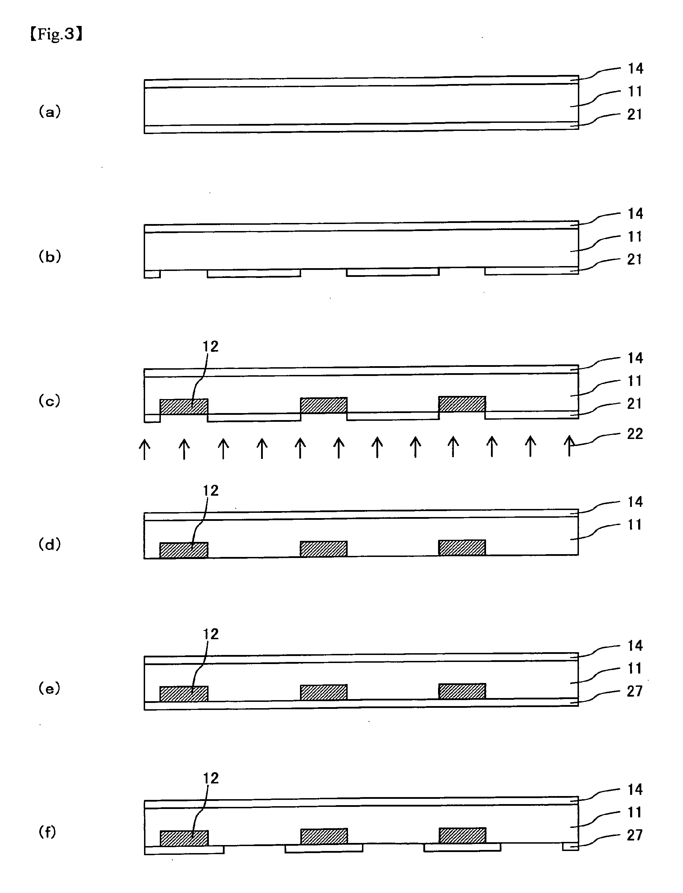

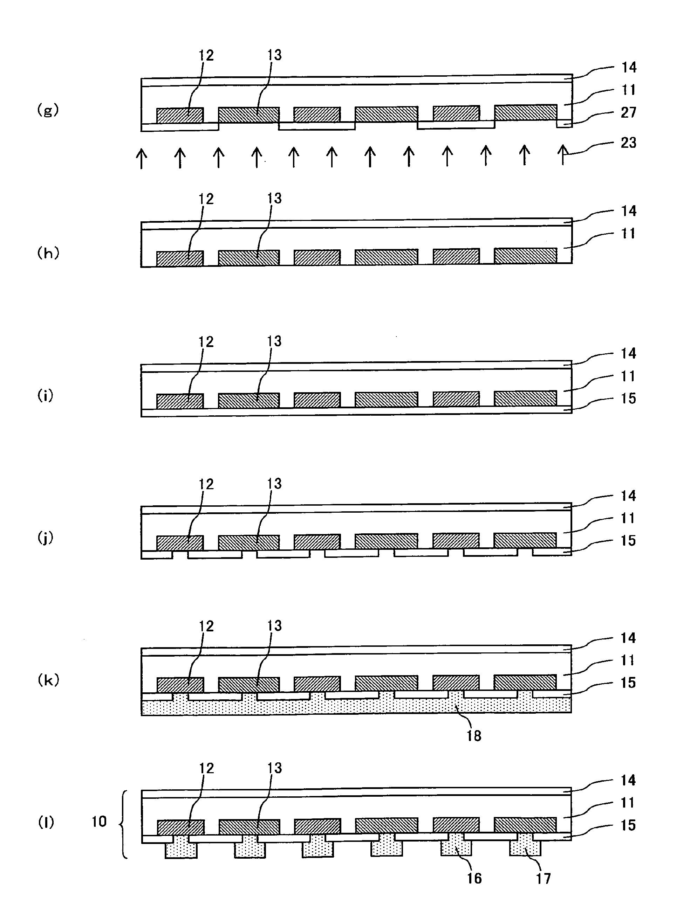

High-precision pattern processing is required for a back-contact solar cell because n-type regions and p-type regions and also the passivation layer and electrodes corresponding thereto are intensively formed as patterns only on the back side. Fig. 3 shows an example of a conventional manufacturing method using photolithography in which after a thin film intended for pattern processing is formed on an entire surface, a photoresist is exposed and developed, the thin film is etched, and the photoresist is removed.

First, (a) a passivation layer 14 is formed on the entire surface of the light receiving side of a semiconductor substrate 11 and a diffusion mask 21 is formed on the entire surface of the back side (opposite side to the light receiving side) thereof, and (b) the diffusion mask 21 is patterned by photolithography. Next, (c) a n-type region 12 is formed by vapor-phase diffusion of an n-type dopant 22 at high temperature in a region of the semiconductor substrate 11 where the diffusion mask 21 is not present and (d) the diffusion mask 21 is removed. Next, (e) a diffusion mask 27 is formed on the entire surface of the back side of the semiconductor substrate 11 and (f) the diffusion mask 27 is patterned by photolithography. Next, (g) a p-type region 13 is formed by vapor-phase diffusion of an n-type dopant 23 at high temperature in a region of the semiconductor substrate 11 where the diffusion mask 27 is not present, and (h) the diffusion mask 27 is removed. Subsequently, (i) a passivation layer 15 is formed on the entire surface of the back side of the semiconductor substrate 11 and (j) the passivation layer 15 is patterned by photolithography. Lastly, (k) an electrode layer 18 to be the n-type contact electrode 16 and the p-type contact electrode 17 is formed on the entire surface, and (l) the electrode layer 18 is patterned to the n-type contact electrode 16 and the p-type contact electrode 17 by photolithography to obtain a back-contact solar cell 10.

For the photolithography, a technology to diffuse the n-type dopant and the p-type dopant simultaneously by devising a process of the solid-phase diffusion method to omit patterning of an n-type or p-type solid-phase dopant source is disclosed (Patent Literature 1).

On the other hand, instead of using photolithography, research has been continued on the simplification of the manufacturing process of a back-contact solar cell by applying an etching paste, masking paste, doping paste, electrode paste or the like as a pattern (Patent Literatures 2 to 4). The etching paste is used for etching a diffusion mask formed on entire surface, the masking paste is used for patterning a diffusion mask, the doping paste is used for patterning a solid-phase dopant source, and the electrode paste is used for patterning a contact electrode. For pattern application of these pastes, a printing method such as screen printing is used.

Research has also been continued on the application of a doping paste by an inkjet printing method as a method of contactlessly applying a paste as a pattern (Patent Literatures 4 and 5). Further, as a contactless pattern application method, a technology of realizing stripe-shaped application by ejecting a solution from a plurality of protruding portions arranged in a longitudinal direction of an application nozzle is disclosed (Patent Literatures 6 and 7).

### Citation List

### Patent Literature

Patent Literature 1: United States Patent No. 4927770
Patent Literature 2: Japanese Patent Application Laid-Open No. 2008-186927
Patent Literature 3: Japanese Patent Application Laid-Open No. 2010-205839
Patent Literature 4: International Publication No. 2007/081510
Patent Literature 5: Japanese Patent Application Laid-Open No. 2004-221149
Patent Literature 6: Japanese Patent Application Laid-Open No. 2003-080147
Patent Literature 7: Japanese Patent Application Laid-Open No. 2007-187948

### Summary of Invention

### Technical Problem

However, the method of repeatedly applying photolithography with many processes described above has a problem of increasing manufacturing costs of solar cells. Also according to the method of forming the n-type region 12 and the p-type region 13 by solid-phase diffusion, it becomes necessary to pattern an n-type solid-phase dopant source and a p-type solid-phase dopant source by photolithography. According to the technology in Patent Literature 1, n-type and p-type dopants can be diffused simultaneously, but the whole process is still very long. Instead of exposing/developing a photoresist, a method of applying the resist by screen printing as a pattern is also known, but the number of whole processes that pattern diffusion masks and solid-phase dopant sources is not significantly reduced.

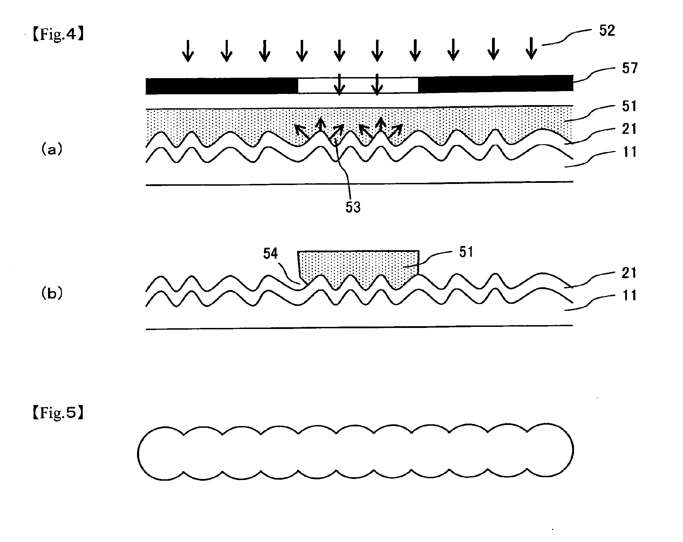

Further, in a commercially available back-contact solar cell, as shown in Fig. 4, innumerable irregularities (for example, irregularities whose width is 20 to 70 µm and whose depth is 1 to 3 µm) are present on the back side of the semiconductor substrate 11. Thus, if an attempt is made to pattern the diffusion mask 21 by photolithography on the back side of the semiconductor substrate 11, the following problems arise when a negative type photoresist 51 used for the patterning is exposed and developed via a photomask 57:
(a) Unevenness of exposure of the photoresist is likely to arise because the angle of bottom reflection of exposure changes due to irregularities.
(b) If the exposure is not sufficient, the photoresist cannot be patterned with high precision because a bottom 54 of the photoresist in a recess tends to be more likely to be developed (eroded).

The printing method like screen printing is applied in the technology disclosed by Patent Literatures 2 to 4, and according to the printing method, a printing plate (or a screen plate for screen printing) comes into contact with a semiconductor substrate, which may give a tiny scratch to the semiconductor substrate, making a contaminant more likely to adhere due to the scratch. Particularly a masking paste and a doping paste are applied to a surface of semiconductor substrate having no passivation layer formed thereon and performance of a solar cell is degraded under the influence of tiny scratches formed on the semiconductor substrate when the printing plate comes into contact or adhering contaminants. Further, semiconductor substrates have been demanded to be thinner to reduce costs in recent years, but a thinner semiconductor substrate leads to less strength, making the semiconductor substrate more likely to be broken when a printing plate comes into contact. A screen plate is produced by being fixed to a frame while tension is being applied to a thin plate having an opening and further is pushed by a squeegee during printing, elongating the screen plate. Thus, the position of the opening is error-prone and it is difficult to reach the precision of pattern application of ±5 µm. In addition, when, for example, n-type and p-type doping pastes are printed, unless contact resistance to the screen plate is made complete by first applying one paste and then solidifying the paste, the other paste cannot be printed. That is, a solidifying process is needed for each paste to be applied.

On the other hand, according to the inkjet printing method described in Patent Literatures 4 and 5, breaking of a semiconductor substrate and the influence of scratches and contaminants can be avoided because an inkjet nozzle and the semiconductor substrate do not come into contact. However, a formed application pattern is, as shown in Fig. 5, a combined shape of a plurality of circles and patterning of a stripe shape with high precision is limited. Particularly in a semiconductor substrate having irregularities present on the back side, applied ink is likely to flow into a recess, making patterning with high precision more difficult.

Further, according to the technology disclosed by Patent Literatures 6 and 7, breaking of a semiconductor substrate and the influence of scratches and contaminants can be avoided because an application nozzle and the semiconductor substrate do not come into contact. Then, a solution is continuously ejected and so a stripe shape can be applied as a pattern. However, these technologies were developed mainly for the manufacture of liquid crystal display color filters. Thus, to realize a high-precision stripe application pattern, it is necessary to provide a bank called a black matrix between adjacent application patterns of different colors (RGB) so that such application patterns will not come into contact. A typical solution to be used for the manufacture of liquid crystal display color filters has a viscosity of about 10 mPa·s in an application nozzle orifice at room temperature and a typical boiling point of a solvent is at as high as about 200°C, the drying speed is slow, and the amount of application is relatively large (a typical thickness after drying is about 1 µm). Thus, the bank is generally further coated with a repellent so that application patterns will not come into contact. Therefore, when two or more different solutions are applied as patterns in a stripe shape, it is necessary to pattern the bank to partition such patterns by photolithography or coat the bank with a repellent in advance, which makes the simplification of processes not so promising even if the technology is applied to the manufacture of back-contact solar cells.

Thus, according to conventional technology, various kinds of pastes to be used cannot be applied as patterns in a stripe shape with high precision while the manufacturing process of semiconductor devices such as back-contact solar cells are simplified. Particularly, there is no technique to apply a masking paste or a doping paste whose viscosity (for example, 10 to 500 mPa·s in an application environment at room temperature) is relatively lower than the viscosity of a typical ink for screen printing as a pattern with high precision without adversely affecting the surface of the semiconductor substrate and increasing the number of processes. Further, this problem is apparent for a semiconductor substrate having random irregularities present on the back side.

An object of the present invention is to provide a manufacturing method capable of solving the above problems and reducing costs of a semiconductor device such as a back-contact solar cell by realizing high-precision pattern application with a smaller process number.

### Solution to Problem

The present invention to solve the above problems includes one of the following configurations of (1) to (12):
(1) A method for manufacturing a semiconductor device, being characterized in that a p-type region and/or n-type pattern is formed on a surface of a semiconductor substrate, including a step of ejecting at least one of etching paste, masking paste, doping paste, and electrode paste from an ejecting orifice of a nozzle toward the surface of the semiconductor substrate to form beads formed of the paste between the semiconductor substrate and the ejecting orifice and of moving the semiconductor substrate relative to the nozzle thereby the paste is applied to the surface of the semiconductor substrate in a stripe shape.
(2) The method for manufacturing a semiconductor device according to (1), wherein the semiconductor device is a back-contact solar cell having a pn junction formed on a side opposite to a light receiving side of the semiconductor substrate.
(3) The method for manufacturing a semiconductor device according to (1) or (2), wherein half or more of solvent components contained in the paste by weight is a solvent whose boiling point is 150°C or higher and 210°C or lower.
(4) The method for manufacturing a semiconductor device according to one of (1) to (3), wherein some paste of the etching paste, the masking paste, the doping paste, or the electrode paste is applied to the semiconductor substrate in the stripe shape and then, the other paste is applied to the semiconductor substrate in the stripe shape while the paste firstly applied remains on the semiconductor substrate.
(5) The method for manufacturing a semiconductor device according to one of (1) to (3), wherein a solid-phase dopant source is patterned by heating the semiconductor substrate after one of n-type and p-type doping pastes is applied to the semiconductor substrate in the stripe shape, and the other doping paste is applied in the stripe shape by using the solid-phase dopant source as a bank.
(6) The method for manufacturing a semiconductor device according to one of (1) to (5), wherein a patterned passivation layer is formed on a back side of the semiconductor substrate and the doping paste is applied to an opening of the passivation layer in the stripe shape.
(7) The method for manufacturing a semiconductor device according to one of (1) to (6), wherein at least two of the etching paste, the masking paste, the doping paste, and the electrode paste are applied together.
(8) The method for manufacturing a semiconductor device according to one of (1) to (6), wherein n-type and p-type doping pastes are applied together.
(9) The method for manufacturing a semiconductor device according to one of (1) to (8), wherein the paste is applied to the surface of the semiconductor substrate in a comb shape by successively forming a connection portion in which the paste is connected in a horizontal direction and a stripe portion in which the paste is separated.
(10) A back-contact solar cell, including a semiconductor substrate having irregularities in random shapes present at least on one surface, wherein n-type regions and p-type regions are formed in a stripe shape crossing the irregularities on the surface of the semiconductor substrate and longer sides of the n-type regions and the p-type regions are linear.
(11) The back-contact solar cell according to (10), wherein a maximum protruding portion on the longer side of each of the n-type region and the p-type region is in a range within 20 µm from a reference line obtained by linear approximation by excluding 10% of points of measurement with great distances from a straight line obtained by approximation of the longer side of each of the longer sides based on the least square method.
(12) The back-contact solar cell according to (10) or (11), wherein the maximum protruding portions of the longer side of each of the n-type region and the p-type region are located in a position corresponding to a convex portion of the semiconductor substrate.

### Advantageous Effects of Invention

According to a manufacturing method of the present invention, a doping paste or the like can be applied as a pattern with high precision in a stripe shape and therefore, the manufacturing process of a semiconductor device such as back-contact solar cell can significantly be reduced and the reduction in cost can be realized. Also according to the manufacturing method of the present invention, the application method is a contactless method and thus, a high-performance semiconductor device (for example, a high conversion efficiency solar cell) can be provided without adversely affecting a semiconductor substrate. Further, according to a back-contact solar cell of the present invention, n-type and p-type doped regions are linearly shaped with precision even if random tiny irregularities are present on a surface on which doped regions of the semiconductor substrate are formed. Therefore, characteristics variations of the pn junction decrease so that reliability of the solar cell can greatly be improved.

### Brief Description of Drawings

Fig. 1 is a sectional view showing a typical structure of a back-contact solar cell.
Fig. 2 is a plan view when Fig. 1 is viewed from a back side.
Fig. 3 is a sectional view showing an example of a method for manufacturing the back-contact solar cell according to a conventional method.
Fig. 4 is a sectional view showing an example of a patterning process of a photoresist by a conventional photolithography (diagram in which the back side is directed upward).
Fig. 5 is a plan view showing an example of a stripe shape formed by a conventional inkjet printing method.
Fig. 6 is a sectional view showing an example of the method for manufacturing the back-contact solar cell according to the present invention.
Fig. 7 is a sectional view showing another example of the method for manufacturing the back-contact solar cell according to the present invention.
Fig. 8 is a sectional view showing still another example of the method for manufacturing the back-contact solar cell according to the present invention.
Fig. 9 is a plan view showing a solid-phase dopant source patterned in a comb shape.
Fig. 10 is a plan view showing an example of the back-contact solar cell using a semiconductor substrate having irregularities on the back side (diagram viewed from the back side).
Fig. 11 is a sectional view of Fig. 10 (diagram in which the back side is directed upward).
Fig. 12 is a sectional view showing still another example of the method for manufacturing the back-contact solar cell according to the present invention.
Fig. 13 is a perspective view showing a coating applicator using in Example 1.
Fig. 14 is a sectional view showing a state in which paste is applied in the stripe shape.
Fig. 15 is a sectional view showing the state in which the paste extruded from a plurality of ejecting orifices is connected in a nozzle width direction in an initial stage of paste application.
Fig. 16 is a perspective view showing the coating applicator used in Example 7.
Fig. 17 is a sectional view showing the manufacturing process of the back-contact solar cell according to Comparative Example 2.
Fig. 18 is a sectional view showing the manufacturing process of the back-contact solar cell according to Comparative Example 3.

### Description of Embodiments

### (First Embodiment: Manufacturing method forming solid-phase dopant sources with clearance between them)

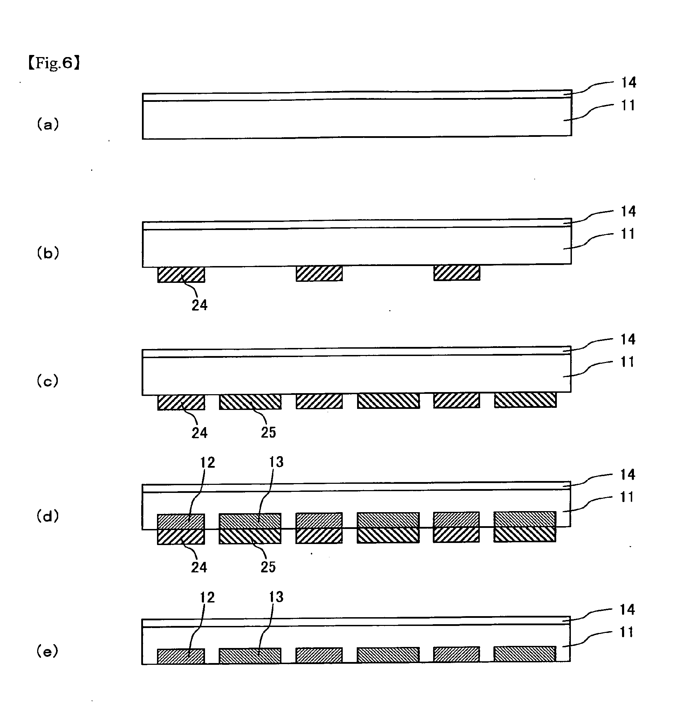

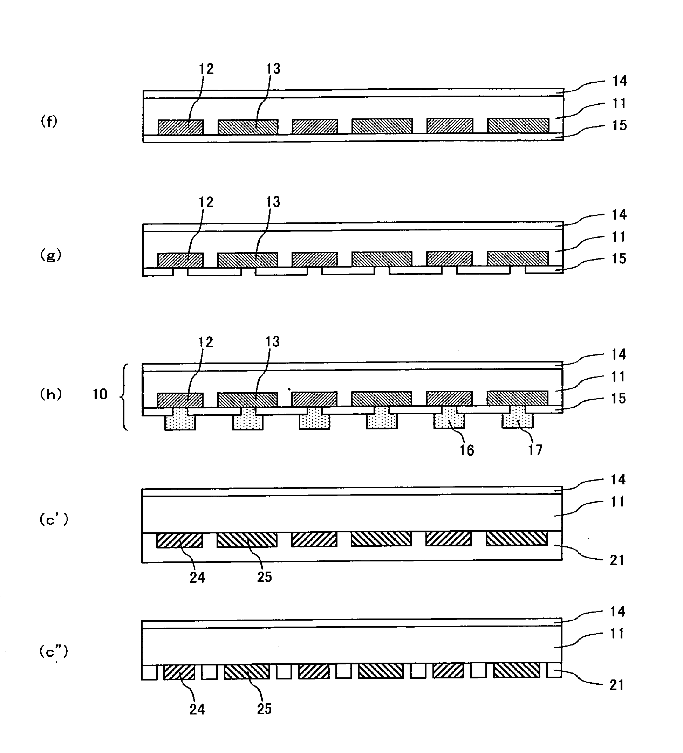

To describe an embodiment of the present invention, a mode of the manufacturing process of a back-contact solar cell will be described using Fig. 6. An example in which an n-type silicon semiconductor is used as the semiconductor substrate 11 and the single-layer passivation layer 14 is used on the light receiving side will be described below, but the present invention is not limited to the above example. P-type silicon or a semiconductor other than silicon may be used as the semiconductor substrate 11 and a textured structure or an antireflection layer including a plurality of layers may be formed on the light receiving side of the semiconductor substrate 11 to reduce light reflection losses.

First, the typical n-type silicon semiconductor substrate 11 whose impurity concentration is 10¹⁵ to 10¹⁶/cm³ is prepared. The silicon semiconductor substrate 11 preferably has the thickness of 50 to 300 µm and an outer shape in an approximately quadrangular shape whose one side is 100 to 250 mm. It is also preferable to etch the surface thereof using a fluoric acid solution or alkali solution to remove slice damage and naturally-grown oxide. Processes of (a) to (h) shown below are performed on the semiconductor substrate 11 in sequence.

(a) The passivation layer 14 is formed on the light receiving side of the semiconductor substrate 11. A publicly known passivation layer such as silicon oxide and silicon nitride formed by the method such as CVD method, thermally-grown oxidation, and spin-on-glass (SOG) method can be applied as the passivation layer 14.

(b) An n-type doping paste is ejected from an ejecting orifice of a nozzle toward the back side (surface on the opposite side of the light receiving side) of the semiconductor substrate 11. In this case, small clearance is formed between the semiconductor substrate 11 and the ejecting orifice and a portion of the clearance is filled with a liquid including the doping paste to form a liquid column, so-called beads. The paste is applied in a stripe shape by moving the semiconductor substrate 11 relative to the nozzle while maintaining beads and an n-type solid-phase dopant source 24 is formed by baking the paste at 200 to 600°C. Moving the semiconductor substrate 11 relative to the nozzle means changing a physical relationship between the semiconductor substrate 11 and the nozzle and one of the semiconductor substrate 11 and the nozzle may be moved or both may be moved at different speeds or in the opposite directions.

Similarly, (c) a p-type solid-phase dopant source 25 is formed by applying a p-type doping paste to between the n-type solid-phase dopant sources 24 and baking the p-type doping paste at 200 to 600°C. The thickness of the solid-phase dopant sources is preferably 100 nm to 1 µm and the p-type solid-phase dopant source 25 is preferably wider than the n-type solid-phase dopant source 24. The pitch of the n-type solid-phase dopant source 24 and the p-type solid-phase dopant source 25 is preferably designed to 0.2 to 2 mm.

(d) The semiconductor substrate 11 is heated to 850 to 1100°C under publicly known conditions such as in nitrogen or nitrogen mixed with oxygen. In this manner, the n-type dopant and the p-type dopant contained in the n-type solid-phase dopant source 24 and the p-type solid-phase dopant source 25 are diffused into the semiconductor substrate 11 in a solid phase to form the n-type region 12 and the p-type region 13 respectively. Typical impurity concentrations of these doped regions are preferably adjusted to 10¹⁷ to 10²⁰/cm³ by controlling the amount of diffusion of the n-type dopant and the p-type dopant. The contact of the n-type region 12 and the p-type region 13 adversely affects performance of solar cells and thus, it is preferable to form the n-type region 12 and the p-type region 13 with a spacing therebetween. The order of forming the n-type solid-phase dopant source 24 and the p-type solid-phase dopant source 25 is not specifically limited. It is preferable to diffuse the n-type and p-type dopants simultaneously like the present embodiment in terms of process simplification, but, for example, after the n-type dopant is diffused by forming the n-type solid-phase dopant source 24, the p-type solid-phase dopant source 25 may be formed and vice versa. Further, one of the n-type solid-phase dopant source 24 and the p-type solid-phase dopant source 25 may be formed by the method of stripe application due to the present invention and the other may be formed by a publicly known method such as screen printing.

(e) The n-type solid-phase dopant source 24 and the p-type solid-phase dopant source 25 are removed by etching using fluoric acid or the like. At this point, the passivation layer 14 formed on the light receiving side may be protected with a resist or the like.

Next, (f) the passivation layer 15 is formed on the entire surface of the back side of the semiconductor substrate 11 and (g) the passivation layer 15 is patterned by photolithography or the like. The passivation layer 15 can be formed by the method like the CVD method and thermally-grown oxidation and a publicly known passivation layer such as silicon oxide and silicon nitride that can be etched by fluoric acid or the like can be applied. For patterning of the passivation layer 15, a masking paste can be ejected from the ejecting orifice of the nozzle, like when the solid-phase dopant source is formed, so as to form beads and the semiconductor substrate 11 and the nozzle are relatively moved for application and then, the masking paste is baked. By using a mask formed as described above, the passivation layer 15 can also be patterned with high precision. Alternatively, only a portion of the passivation layer 15 where etching paste is present may be etched by first forming the passivation layer 15 on the entire surface, ejecting an etching paste from the ejecting orifice of the nozzle, like when the solid-phase dopant source is formed, so as to form beads, moving the semiconductor substrate 11 and the nozzle relatively for application and then, heating the semiconductor substrate 11. Also in this manner, the passivation layer 15 can be patterned with high precision.

Lastly, (h) the n-type contact electrode 16 and the p-type contact electrode 17 are formed by applying an electrode paste as a pattern by the screen printing or the like and baking the electrode paste to obtain the back-contact solar cell 10. Incidentally, like when the solid-phase dopant source is formed, the electrode paste may be ejected from the ejecting orifice of the nozzle so as to form beads, the semiconductor substrate 11 and the nozzle may be moved relatively for paste application, and then the paste is heated. In this manner, the contact electrode can be patterned with high precision. Single metals such as gold, silver, palladium, aluminum, titanium, and nickel or alloys, laminated films thereof can be used as the contact electrode. A publicly known technology to lower contact resistance by diffusing a portion of the electrode material into a doped region can also be used. As shown in Fig. 2, the n-type contact electrode 16 and the p-type contact electrode 17 are preferably formed in a comb shape in which respective ends are connected.

The embodiment illustrated in Fig. 6 applies a pattern with high precision so as to maintain clearance between the n-type solid-phase dopant source 24 and the p-type solid-phase dopant source 25 constant. It is difficult to describe about viscosity in general because details depend on the pitch, width, and interval; however, among the etching paste, masking paste, doping paste, and electrode paste, particularly the masking paste and doping paste based on the SOG technology have relatively low typical viscosity of 3 to 3000 mPa·S, particularly preferably 10 to 500 mPa·S in an application environment at room temperature. Thus, the paste after being applied in a stripe shape is unable to maintain the form and tends to spread, making high-precision patterning without a bank difficult. However, according to the present invention, the paste can be applied in a stripe shape with high precision because the paste is ejected from the ejecting orifice of the nozzle so that beads of the paste are formed while at least one of the nozzle and the semiconductor substrate is moved so that the relative position of the nozzle with the paste applied thereon and the semiconductor substrate changes.

To apply even a paste having low viscosity in a stripe shape with high precision, half or more of solvent components contained in the paste by weight is preferably a solvent whose boiling point is 150°C to 210°C. If the boiling point of the solvent is 150°C or higher, drying of the nozzle tip can be prevented. On the other hand, if the boiling point of the solvent is 210°C or lower, the drying speed of the paste can relatively be increased. Thus, by adopting the above configuration, degradation in pattern precision due to changes of the application width and wettability to the foundation between the application and drying can be limited.

It is also preferable to selectively coat a portion corresponding to clearance between the n-type solid-phase dopant source 24 and the p-type solid-phase dopant source 25 to be formed later with a repellent by a publicly known method before the n-type doping paste shown in Fig. 6(b) is applied. Accordingly, the stripe application can be made more precise. Because a bank is not formed but the application surface of the semiconductor substrate 11 is directly coated with a repellent, the increased process number is limited to a minimum and if a repellent material is selected, an influence of impurity mixing in subsequent thermal diffusion can be limited.

In the above embodiment, the n-type doping paste is ejected toward the semiconductor substrate and the semiconductor substrate is once heated to form the n-type solid-phase dopant source 24 and then, the p-type doping paste is ejected toward the semiconductor substrate, but while the n-type doping paste applied in a stripe shape remains (that is, before the doping paste is formed into a solid-phase dopant source), the p-type doping paste may be applied in a stripe shape therebetween. According to conventional screen printing, a screen plate first comes into contact with the n-type solid-phase dopant source 24 and cannot be completely brought into close contact with the semiconductor substrate 11 when the p-type doping paste is printed even after the n-type doping paste is completely solidified, making high-precision pattern application of the p-type doping paste difficult. Further, if the n-type doping paste is not completely solidified, there lies a serious problem such as adhesion of the n-type doping paste to the screen plate when the p-type doping paste is printed. In the present invention, however, paste is applied without contact of the screen plate, etc. with the semiconductor substrate and thus, after some paste being applied in a stripe shape, another paste can be applied in a stripe shape while the paste remains whether or not being baked or in the solidified state. As a result, high-precision pattern application can be realized with a small process number.

In the present invention, (c') the diffusion mask 21 covering the n-type solid-phase dopant source 24 and the p-type solid-phase dopant source 25 can be formed by applying a masking paste to the entire surface after the state shown in Fig. 6 (c) being formed and before the process shown in Fig. 6(d). In this manner, contamination of a clearance portion between the n-type solid-phase dopant source 24 and the p-type solid-phase dopant source 25 by the vapor phase, which greatly affects pn junction characteristics, and impurity diffusion from the n-type solid-phase dopant source 24 and the p-type solid-phase dopant source 25 into the vapor phase can be prevented and, as a result, the back-contact solar cell 10 exhibiting higher performance can be manufactured.

Further, (c") the diffusion mask 21 can be formed with clearance between the n-type solid-phase dopant source 24 and the p-type solid-phase dopant source 25 after the state shown in Fig. 6(c) being formed and before the process shown in Fig. 6(d). In this manner, it becomes possible to manufacture the high-performance back-contact solar cell 10 because a low-concentration doped region can be formed in a clearance portion.

### (Second Embodiment: Manufacturing method of forming a solid-phase dopant source without creating clearance)

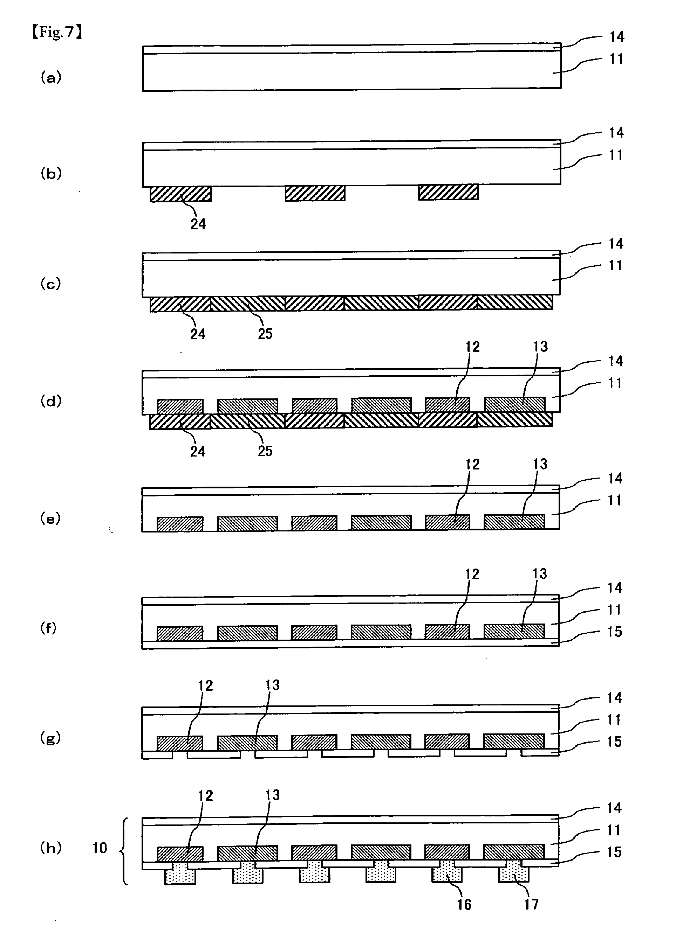

To further describe the present invention, the manufacturing method of another back-contact solar cell will be described using Fig. 7. First, like Fig. 6, (a) the passivation layer 14 is formed on the light receiving side of the semiconductor substrate 11. Subsequently, (b) an n-type doping paste is ejected from the ejecting orifice of the nozzle toward the back side of the semiconductor substrate 11 to form beads formed of the doping paste between the semiconductor substrate 11 and the ejecting orifice and also applied in a stripe shape by moving the semiconductor substrate 11 relative to the nozzle. Then, the n-type doping paste is baked at 200 to 600°C to form the n-type solid-phase dopant source 24. Next, (c) a p-type doping paste is applied in a stripe shape to between the n-type solid-phase dopant sources 24. A feature of the present embodiment is to make the n-type solid-phase dopant source 25 to function as a bank. Then, by baking the p-type doping paste at 200 to 600°C, the p-type solid-phase dopant source 25 can be formed without creating clearance to the n-type solid-phase dopant sources 24.

Then, (d) the semiconductor substrate 11 is heated to 850 to 1100°C under publicly known conditions such as in nitrogen or nitrogen mixed with oxygen. In this manner, the n-type dopant and the p-type dopant contained in the n-type solid-phase dopant source 24 and the p-type solid-phase dopant source 25 are diffused into the semiconductor substrate 11 in a solid phase to form the n-type region 12 and the p-type region 13 respectively. In the present embodiment, a region into which both the n-type dopant and the p-type dopant are diffused is likely to be formed between the n-type region 12 and the p-type region 13. In the region, each dopant deactivates one another. Thus, if the diffusive concentration, the time and the like are selected well, an effect similar to the effect of forming two solid-phase dopant sources with spacing therebetween can be achieved.

Then, the back-contact solar cell 10 can be obtained by performing the processes (e) to (h) in the same manner as in Fig. 6.

In the embodiment illustrated in Fig. 7, the n-type solid-phase dopant source 24 formed first is made to function as a bank of the p-type doping paste to be applied next and thus, degradation in precision such as non-uniform clearance between both pastes can be limited and further, usage efficiency of the p-type doping paste can be improved. Needless to say, the p-type solid-phase dopant source 25 may first be formed to apply an n-type doping paste by allowing the p-type solid-phase dopant source 25 to function as a bank. Also, a solid-phase dopant source may be formed by applying a doping paste after selectively coating the application surface of the semiconductor substrate 11 with a repellent, and after removing the coated repellent, if necessary, the next doping paste may be applied by allowing the formed solid-phase dopant source to function as a bank.

Also in the present embodiment, for a reason similar to the reason described in the first embodiment, half or more of solvent components contained in the paste by weight is preferably a solvent whose boiling point is 150°C to 210°C.

Also in the present embodiment, the diffusion mask 21 covering the n-type solid-phase dopant source 24 and the p-type solid-phase dopant source 25 can be formed by applying a masking paste to the entire surface after the state shown in Fig. 7 (c) being formed and before the process shown in Fig. 7(d). In this manner, impurity diffusion from the n-type solid-phase dopant source 24 and the p-type solid-phase dopant source 25 into the vapor phase can be prevented.

### (Third Embodiment: Manufacturing method of forming a solid-phase dopant source after forming a passivation layer)

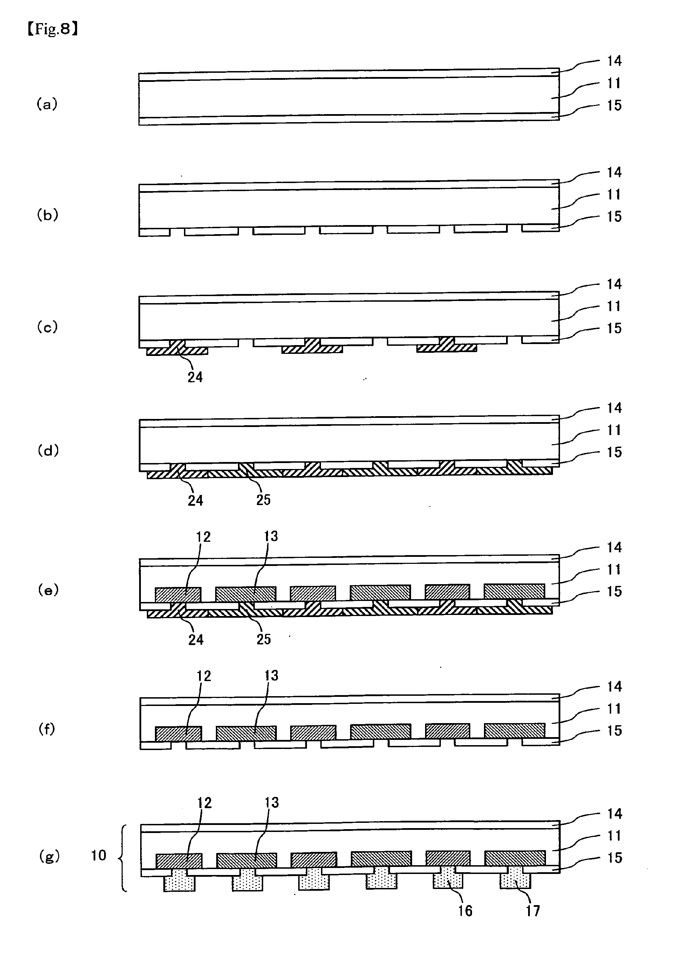

To further describe the present invention, another manufacturing method of a back-contact solar cell will be described using Fig. 8. First, (a) the passivation layer 14 is formed on the entire surface of the front side of the semiconductor substrate 11 and the passivation layer 15 is formed on the entire surface of the back side thereof. Subsequently, (b) the passivation layer 15 is patterned by photolithography to form an opening in a stripe shape in the passivation layer 15. Then, (c) an n-type doping paste is ejected from the ejecting orifice of the nozzle toward the back side of the semiconductor substrate 11 to form beads formed of the doping paste between the semiconductor substrate 11 and the ejecting orifice and also applied in a stripe shape by moving the semiconductor substrate 11 relative to the nozzle. At this point, the n-type doping paste is applied to at least fill up the opening (preferably, the opening is filled up and the n-type doping paste is run on a portion of the passivation layer 15) of the passivation layer 15 corresponding to the position where the n-type solid-phase dopant source 24 is to be formed. Then, the n-type doping paste is baked at 200 to 600°C to form the n-type solid-phase dopant source 24.

Next, (d) a p-type doping paste is applied to at least fill up the opening (preferably, the opening is filled up and the n-type doping paste is run on a portion of the passivation layer 15) of the passivation layer corresponding to the position where the p-type solid-phase dopant source 25 is to be formed. In this case, as shown in Fig. 8, the n-type solid-phase dopant source 24 may be allowed to function as a bank or, separated from the illustrated aspect, the p-type doping paste may be applied with spacing to the n-type solid-phase dopant source 24. The p-type doping paste may be applied not in a stripe shape but to cover the entire surface of the n-type solid-phase dopant source 24. Then, the p-type solid-phase dopant source 25 can be formed by baking the p-type doping paste at 200 to 600°C.

(e) The semiconductor substrate 11 is heated to 850 to 1100°C under publicly known conditions such as in nitrogen or nitrogen mixed with oxygen. In this manner, the n-type dopant and the p-type dopant each contained in the n-type solid-phase dopant source 24 and the p-type solid-phase dopant source 25 are diffused into the semiconductor substrate 11 in a solid phase to form the n-type region 12 and the p-type region 13 respectively. By providing the passivation layer 15 with a function of the diffusion mask, if necessary, the n-type region 12 and the p-type region 13 can be formed relatively easily with spacing therebetween. Obviously, even if a region into which both the n-type dopant and the p-type dopant are diffused between the n-type region 12 and the p-type region 13 is formed, the n-type dopant and the p-type dopant deactivate one another in the region and therefore, an effect of creating spacing between the n-type region 12 and the p-type region 13 can be achieved.

Next, in the same manner as in Fig. 6(e), (f) the n-type solid-phase dopant source 24 and the p-type solid-phase dopant source 25 are removed by etching using fluoric acid or the like. Then, an interface between the passivation layer 15 and the semiconductor substrate 11 can be reformed by hydrogenation disclosed in Patent Literature 1 if necessary.

Lastly, in the same manner as in Fig. 6(h), (g) the n-type contact electrode 16 and the p-type contact electrode 17 are formed by applying an electrode paste as a pattern by the screen printing or the like and baking the electrode paste to obtain the back-contact solar cell 10.

In the embodiment illustrated in Fig. 8, since the passivation layer 15 is first patterned and then a solid-phase dopant source is formed, the precision of stripe application can be improved by utilizing a difference of wettability of the doping paste to the application surface of the semiconductor substrate 11 exposed from the opening of the passivation layer 15 and the passivation layer 15. It is also preferable, like the first embodiment, to provide a coating of repellent before the doping paste is applied and in that case, the passivation layer 15 can selectively be coated with a repellent. Thus, when compared with a case when the application surface of the semiconductor substrate 11 is directly coated with a repellent, an effect of reducing an adverse effect on the semiconductor substrate 11, for example, can be expected. In Fig. 8(f), the passivation layer 15 as well as the n-type solid-phase dopant source 24 and the p-type solid-phase dopant source 25 are removed simultaneously to pattern the passivation layer 15 again later.

In the present embodiment, like the first embodiment, the order of the process of forming the n-type solid-phase dopant source 24 and the process of forming the p-type solid-phase dopant source 25 may be reversed. In addition, before a solid-phase dopant source is formed by heating one doping paste, the other doping paste may be ejected toward the semiconductor substrate to heat both doping pastes together.

Also in the present embodiment, for a reason similar to the reason described in the first embodiment, half or more of solvent components contained in the paste by weight is preferably a solvent whose boiling point is 150°C to 210°C.

Further, also in the present embodiment, a diffusion mask covering the n-type solid-phase dopant source 24 and the p-type solid-phase dopant source 25 can be formed by applying a masking paste to the entire surface after the state shown in Fig. 8 (d) being formed and before the process shown in Fig. 8(e). In this manner, impurity diffusion from the n-type solid-phase dopant source 24 and the p-type solid-phase dopant source 25 into the vapor phase can be prevented. If the n-type solid-phase dopant source 24 and the p-type solid-phase dopant source 25 are provided with clearance therebetween, contamination from the vapor phase into a portion between the clearances which greatly affects pn junction characteristics can be prevented. As a result, the back-contact solar cell 10 exhibiting higher performance can be manufactured.

If the n-type solid-phase dopant source 24 and the p-type solid-phase dopant source 25 are provided with clearance therebetween, a diffusion mask can be formed by creating clearance between the n-type solid-phase dopant source 24 and the p-type solid-phase dopant source 25 after forming the state shown in Fig. 8(d) and before proceeding to the process shown in Fig. 8(e). In this manner, the high-performance back-contact solar cell 10 can be manufactured because a low-concentration doped region can be formed in the clearance portion.

### (Fourth Embodiment: a manufacturing method in which a diffusion mask is first provided on a semiconductor substrate having irregularities on the surface thereof to form an n-type solid-phase dopant source and to provide a p-type solid-phase dopant source after an n-type region is formed)

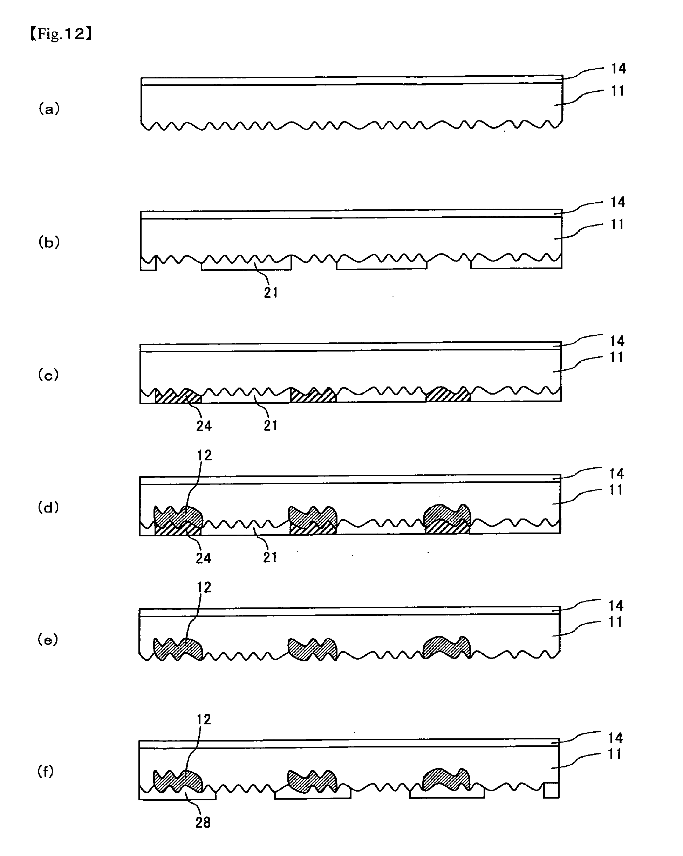

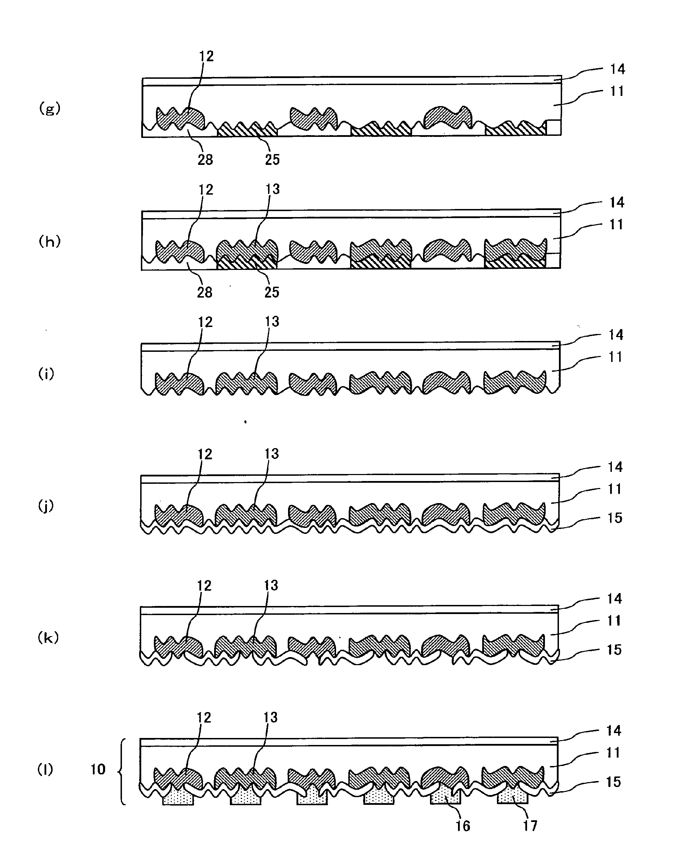

To further describe the present invention, another manufacturing method of a back-contact solar cell will be described using Fig. 12. First, (a) the passivation layer 14 is formed on the light receiving side of the semiconductor substrate 11. Subsequently, (b) a masking paste is ejected from the ejecting orifice of the nozzle toward the back side of the semiconductor substrate 11 having irregularities in irregular shapes to form beads formed of the masking paste between the semiconductor substrate 11 and the ejecting orifice and also applied in a stripe shape by moving the semiconductor substrate 11 relative to the nozzle. Then, the masking paste is baked at 200 to 1000°C to form the diffusion mask 21.

Next, (c) an n-type doping paste is applied in a stripe shape to between the diffusion masks 21. At this point, the diffusion mask 21 is allowed to function as a bank. Like the process in (b), beads formed of the doping paste are formed between the semiconductor substrate 11 and the ejecting orifice and the semiconductor substrate 11 is moved relative to the nozzle. Then, the n-type solid-phase dopant source 24 is formed without creating clearance to the diffusion masks 21 by baking the n-type doping paste at 200 to 600°C.

Subsequently, (d) the semiconductor substrate 11 is heated to 850 to 1100°C under publicly known conditions such as in nitrogen or nitrogen mixed with oxygen to diffuse the n-type dopant contained in the n-type solid-phase dopant source 24 into the semiconductor substrate 11 in a solid phase to form the n-type region 12. Then, (e) the diffusion masks 21 and the n-type solid-phase dopant source 24 are removed by etching using fluoric acid or the like.

Next, (f) a masking paste is applied in a stripe shape to cover the formed n-type region 12. Like the process in (b), beads formed of the masking paste are formed between the semiconductor substrate 11 and the ejecting orifice and the semiconductor substrate 11 is moved relative to the nozzle. Then, the masking paste is baked at 200 to 1000°C to form a diffusion mask 28.

Subsequently, (g) the diffusion mask 28 is allowed to function as a bank and meanwhile a p-type doping paste is applied in a stripe shape. At this point, like the process in (b), beads formed of the doping paste are formed between the semiconductor substrate 11 and the ejecting orifice and the semiconductor substrate 11 is moved relative to the nozzle. Then, the p-type solid-phase dopant source 25 is formed without creating clearance to the diffusion masks 28 by baking the n-type doping paste at 200 to 600°C.

(h) Then, in the same manner as (d), the p-type dopant contained in the p-type solid-phase dopant source 25 is diffused into the semiconductor substrate 11 in a solid phase to form the p-type region 13 and (i) the diffusion masks 28 and the p-type solid-phase dopant source 25 are removed by etching using fluoric acid or the like.

Then, the processes (j) to (l) are performed in the same manner as the processes (f) to (h) in Fig. 7.

In the present embodiment, since random tiny irregularities are present on the surface of the semiconductor substrate 11, the masking paste is likely to flow from a convex portion into a recess portion of the semiconductor substrate 11. Thus, the width of the diffusion masks 21, 28 may become partially wider than desired if the masking paste is applied by maintaining apparatuses and the amount of ejected paste constant. In that case, the n-type solid-phase dopant source 24 and the p-type solid-phase dopant source 25 and further, the n-type region 12 and the p-type region 13 will be partially narrower in width than desired. Thus, it is preferable to appropriately set and change application conditions of paste by considering tiny irregularities on the substrate surface and flowability of the paste. However, according to the present invention, even if a width is changed as described above, the width between the n-type region 12 and the p-type region 13 changes toward making the width wider than desired and the maximum protruding portion on the longer side of each of the n-type region and the p-type region is present in a position corresponding to a convex portion of the semiconductor substrate and therefore, generation efficiency and reliability of the obtained back-contact solar cell are not affected.

Also in the present embodiment, a diffusion mask formed previously is allowed to function as a bank when each of the n-type and p-type solid-phase dopant sources is formed. Thus, the solid-phase dopant source can be provided in a stripe shape with high precision without actively improving the precision of application of the doping paste itself. Therefore, the doping paste may be applied without forming beads; and even in that case, the solid-phase dopant source can be provided in a stripe shape with high precision.

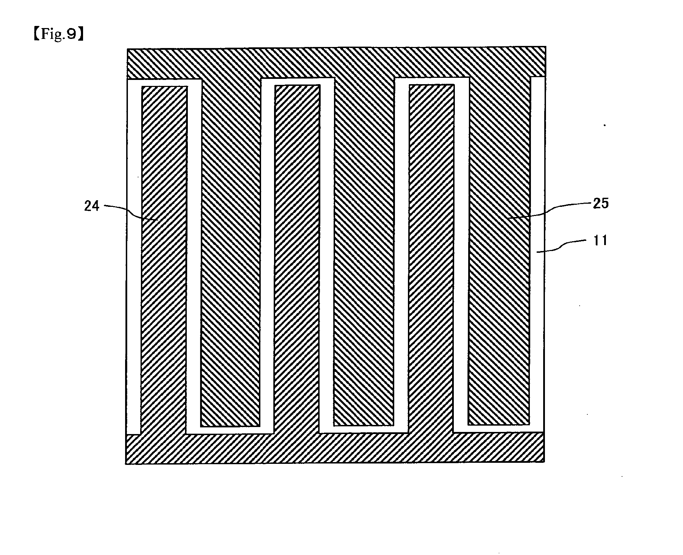

In the first to fourth embodiments, the n-type solid-phase dopant source 24 and the p-type solid-phase dopant source 25 in which paste is formed by being applied in a stripe shape may be, as shown in Fig. 9, a comb shape in which each end is connected to at near the end of semiconductor substrate 11. The n-type solid-phase dopant source and the p-type solid-phase dopant source basically need to be provided repeatedly in one direction in the center portion of the substrate. Thus, to increase the production rate, it is preferable to use a nozzle that supplies paste from one paste storing portion to a plurality of ejecting orifices to eject a plurality of pastes toward the semiconductor substrate at a time. In that case, a stripe shape can be formed with high precision by adopting the comb shape as shown in Fig. 9 for the n-type solid-phase dopant source and the p-type solid-phase dopant source. That is, when paste is applied to a semiconductor substrate from a nozzle as described above at a time, unevenness arises at first because it is difficult to equally supply paste to each ejecting orifice from one paste storing portion. However, the unevenness can be absorbed by adopting the above comb shape and the precision of a stripe portion can be improved.

More specifically, a connection portion of the comb shape is obtained by, for example, creating a state in which beads are connected in a horizontal direction by increasing the amount of ejected paste or slowing the relative speed. Alternatively, beads naturally connected in the horizontal direction may be formed from excessive paste present between the semiconductor substrate and the nozzle in the initial stage of application, and such beads may be used to create the connection portion. On the other hand, a stripe portion can be obtained by creating a state in which beads are separated for each ejecting orifice by decreasing the amount of ejected paste or increasing the relative speed. In this manner, the comb shape can continuously be formed in a series of application operations moving the semiconductor substrate relative to the nozzle.

Incidentally, the application method is not limited to the doping paste that forms a solid-phase dopant source and can be applied to all the pastes that are applied while forming beads between the semiconductor substrate and the ejecting orifice of the nozzle.

When the application method is adopted, it is preferable to set opposite application directions between the n-type doping paste and the p-type doping paste.

In the embodiments illustrated in Figs. 6 to 8, 12, an n-type doping paste is applied in a stripe shape and heated once to form the n-type solid-phase dopant source 24 and then, a p-type doping paste is applied in a stripe shape and heated again to form the p-type solid-phase dopant source 25. According to the present invention, however, doping pastes do not necessarily have to be heated separately as described above and n-type and p-type doping pastes may be heated simultaneously after being collectively applied. If n-type and p-type dopants are diffused in a solid phase by further raising the temperature continuously while using the n-type and p-type doping pastes as solid-phase dopant sources by simultaneous heating, the process number can advantageously be further reduced.

The collective application is not limited to an application of n-type and p-type doping pastes at the same time in a temporally strict sense but can be defined as an application in which the other doping paste is applied before the doping paste applied beforehand actively is dried or heated. Therefore, the collective application is not limited to an application method by which n-type and p-type doping pastes are ejected at the same time from ejecting orifices arranged alternately in the same nozzle but, for example, the collective application can be realized by integrally moving two nozzles relative to the semiconductor substrate in a state where the two separate nozzles corresponding to the n-type and p-type doping pastes are mutually aligned and arranged. Incidentally, the collective application is not limited to a combination of the n-type and p-type doping pastes but may also be applied to a combination of any pastes having different properties or a combination of different application thicknesses (application amount) of the same paste.

In the present invention, an effect improving pattern precision by the collective application can also be expected. The most important precision when back-contact solar cells are manufactured is a relative position of an n-type doped region and/or a p-type doped region. More specifically, such relative positions include the stripe width or center pitch of the same n-type or p-type stripe-shaped doped region and the center pitch and clearance between n-type and p-type doped regions and the most important precision is selected for one of such items in accordance with the purpose.

As described above, the n-type or p-type alone stripe application is error-prone due to an influence of elongation of a screen plate in conventional screen printings; furthermore, since separate n-type and p-type pattern applications are needed, an alignment error in the substrate is added to single errors. Thus, for example, it has been difficult to control clearance between n-type and p-type stripe-shaped doped regions with high precision. According to the present invention, on the other hand, the error of relative positions of important p-type and/or n-type doped regions can be limited to a level of, for example, ±5 µm or less by using not only a robust nozzle with extremely small dimensional changes, but also two nozzles being aligned with high precision for collective application. According to the present invention, edges of each applied paste can advantageously be made linear and, among others, the collective application can be said to be one of the most appropriate pattern application methods in order to control clearance between n-type and p-type stripe-shaped doped regions with high precision.

In the above aspects, methods of applying the doping paste (the first to third embodiments) or the doping paste and masking paste (the fourth embodiment) to a semiconductor substrate in a stripe shape while forming beads are illustrated. In the present invention, however, only one of the doping paste, etching paste, masking paste, and electrode paste or a plurality of pastes may be applied to a semiconductor substrate in a stripe shape while beads are being formed.

In the present invention, the composition of doping paste is not specifically limited as long as a dopant component is contained. For example, publicly known materials including paste to form doped oxide by the SOG method can be used. As a typical composition, at least a matrix material, solvent, and dopant are preferably contained. A publicly known thickener may be added if necessary.

As a preferable matrix material of doping paste, a silicon compound that forms a silica film after baking can be cited. More specifically, alkoxy silanol, alkoxy silane, alkyl silanol, alkyl silane, silsesquixane, silanolate, aromatic substitutions thereof, and siloxane materials in a broad sense obtained by oligomerization thereof can be exemplified. Other vitreous formation materials or organic binders can be added to the matrix material.

The solvent is not specifically limited as long as the solvent dissolves the matrix material and alcohol, ester, ether, aldehyde, ketone, water, ands acid can be exemplified.

Compounds containing phosphorus, arsenic, antimony and the like can be exemplified as the n-type dopant to silicon semiconductor substrate and compounds containing boron, aluminum and the like can be exemplified as the p-type dopant. More specifically, diphosphorus pentaoxide, phosphorus oxide, phosphoric acid, phosphorus based salt, organic phosphorus compounds, boron oxide, boric acid, boron salt, organic boron compounds, boron-aluminum compounds, aluminum salt, and organic aluminum compounds can be cited as preferred examples.

The matrix material is frequently prepared to a concentration of 50 wt% or less in doping paste. The dopant is preferably added in the concentration of 10 wt% or less of the doping paste and particularly preferably in the concentration of 5 wt% or less. Without using any matrix material, a solution including only a dopant and a solvent can be used, but vapor-phase diffusion due to the lack of the matrix material needs to be watched. The viscosity of the doping paste is not specifically limited, but the doping paste is preferably used in the viscosity of 3 to 3000 mPa·s, particularly preferably in the viscosity of 10 to 500 mPa·s.

As the material of masking paste, like the doping paste, a silicon compound that forms a silica film after baking can be cited. More specifically, alkoxy silanol, alkoxy silane, alkyl silanol, alkyl silane, silsesquixane, silanolate, aromatic substitutions thereof, and siloxane materials in a broad sense obtained by oligomerization thereof can be exemplified.

The material of etching paste is not specifically limited, but, for example, a material containing at least one of hydrogen fluoride, ammonium, phosphoric acid, sulfuric acid, and nitric acid as the etching component and also containing water, an organic solvent, thickener and the like as other components is preferable.

Further, a mixture of a conductive particle component of silver, aluminum, copper or the like, a solvent, and/or a polymer component is suitably used as the material of electrode paste. The polymer may remain after baking, but conductivity of electrodes can be improved by allowing the polymer to thermally decompose to improve binding properties of conductive particles. Publicly known materials of acrylic or epoxy materials can be used as the polymer component.

A back-contact solar cell obtained from the present invention described above has, for example, a configuration described below.

If, in general, the matrix of a solid-phase dopant source is a silica film, the solid-phase dopant source is frequently removed by a fluoric acid solution after dopant diffusion. The fluoric acid solution has the capability of etching the semiconductor substrate as a foundation. On the other hand, if the solid-phase dopant source remains even in a trace quantity, the performance of a solar cell is degraded and thus, the semiconductor substrate as a foundation is also usually etched when the solid-phase dopant source is removed. Therefore, according to a back-contact solar cell by a conventional method by which the solid-phase dopant source is patterned by photolithography, even if a semiconductor substrate whose surface is smooth is used, a portion of the semiconductor substrate to be the foundation of one of the n-type solid-phase dopant source and the p-type solid-phase dopant source of the semiconductor substrate is more frequently etched than a portion to be the foundation of the other. As a result, the surface of the semiconductor substrate becomes irregular and a convex portion difference arises between the surfaces of the n-type and p-type regions, causing a problem that quality is likely to be degraded.

According to the present invention, however, the number of times of etching can be reduced and the n-type solid-phase dopant source and the p-type solid-phase dopant source can be removed by etching at a time if necessary. Therefore, the possibility of causing irregularities on the surface of the semiconductor substrate itself by etching can be reduced and also the possibility that a height difference arises between the surfaces of the n-type and p-type regions can be reduced. Further, in the present invention, when a solid-phase dopant source is formed without creating clearance, as illustrated in Fig. 7, no step arises between an n-type region and a p-type region.

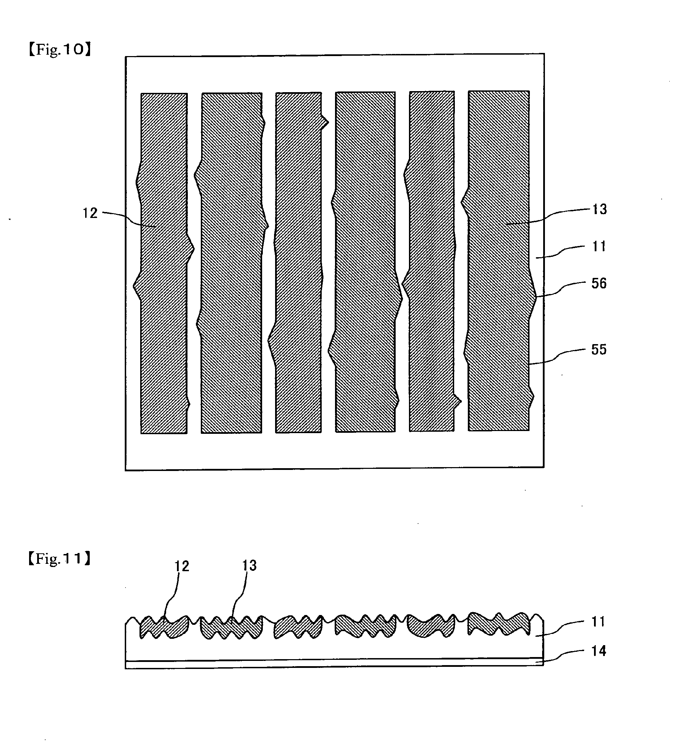

In a back-contact solar cell, as shown in Figs. 10 and 11, the n-type region 12 and the p-type region 13 may be provided in a stripe shape in a semiconductor substrate having innumerable irregularities on the surface thereof to across the irregularities. If irregularities are present on the semiconductor substrate, it is difficult to pattern the n-type region 12 and the p-type region 13 with high precision. According to the method of the present invention, however, it is easy to apply paste linearly and a longer side 55 of each of the n-type region 12 and the p-type region 13 is also likely to be linear. Thus, for example, it is possible to allow the maximum protruding portion on the longer side 55 of each of the n-type region 12 and the p-type region 13 to protrude only up to 20 µm from a reference line described later. If the n-type region 12 and the p-type region 13 are too close, reliability of the back-contact solar cell tends to decrease and therefore, it is preferable that a maximum protruding portion 56 on the longer side 55 of each of the n-type region 12 and the p-type region 13 protrude only in a range of 20 µm from the reference line.

A relative position of an n-type doped region and/or a p-type doped region can easily be measured by analyzing a dopant element diffused into the semiconductor substrate using, for example, a Scanning Electron Microscope with Energy Dispersive X-ray Spectroscopy (SEM-EDX) or the Secondary Ion-microprobe Mass Spectrometer (SIMS). The measuring range of 0.3 to 10 mm square and the measuring pitch of 3 to 300 µm can be exemplified as suitable measurement conditions.

Whether or not the longer side 55 of the doped region is linear is judged as follows. To decide a reference line first, the concentration of the dopant element on the longer side formed in a stripe shape of the n-type region 12 and the p-type region 13 is measured by the above method to determine a boundary line where the concentration is 10 times the average dopant concentration of the semiconductor substrate or more or a boundary line to be a limit of detection if the same type of dopant is not present in the semiconductor substrate. The boundary line corresponds to a longer side of a doped region. The boundary line is linearly approximated by the least square method and then the boundary line is linearly approximated again excluding 10% of points of measurement with great distances from the approximated straight line to set the obtained straight line as the reference line. Then, whether the boundary line is within a range of 1/10 of the width of the doped region from the reference line is judged and if the boundary line is within the range of 1/10 of the width of the doped region, the longer side 55 is judged to be "linear".

Further in the present invention, the width and interval of a doped region formed in a stripe shape are defined by distances between reference lines defined as described above for two target longer sides.

Only the method for manufacturing a back-contact solar cell is illustrated in the above description, but the present invention can be developed for a method for manufacturing a semiconductor device having a p-type and/or n-type region patterned on the semiconductor surface thereof, for example, a transistor array, diode array, photodiode array, and transducer.

### Examples

The present invention will be described below by citing examples, but the present invention is not limited by these examples.

### [Viscosity of paste]

The viscosity of paste was measured using a rotational viscometer (VISCOMETER TV-20 manufactured by Tokyo Keiki Inc.) under the condition of 25°C conforming to JIS Z 8803 (1991) "Liquid Viscosity-Measuring Method".

### [Position/width/interval/linearity of doped regions]

Phosphorus and boron elements as dopants diffused into a semiconductor substrate were analyzed using the secondary ion mass spectroscopy (SIMS). Arbitrary three regions (each was a region of 20 mm in the stripe longitudinal direction and 2 mm in the width direction) were measured and the measuring pitch was set to 10 µm.

### [Withstand voltage measurement]

Arbitrary three pairs of p-type and n-type regions were selected, and the voltage at which the current begins a rapid increase when a reverse bias (the p type was minus and the n type was plus) was applied therebetween was measured. Minimum value thereof was set as the withstand voltage.

### [Example 1 (Manufacturing method of forming a solid-phase dopant source with clearance)]

A back-contact solar cell was manufactured as described below based on the method shown in Fig. 6.

First, the semiconductor substrate 11 formed of n-type single crystalline silicon having the thickness of 250 µm and the length of one side of 100 mm was prepared and both surfaces thereof were etched by about 20 µm by a sodium hydrate solution and polished after water washing to remove slice damage and naturally-grown oxide.

Subsequently, (a) the passivation layer 14 having the thickness of 0.3 µm and formed of silicon nitride was formed on the light receiving side of the silicon substrate 11 by the plasma CVD method.

On the other hand, (b) an n-type doping paste was applied to the application surface (surface on the opposite side of the light receiving side) of the semiconductor substrate 11 in a stripe shape. Then, the n-type doping paste was heated at 150°C for 30 min in the air and then at 500°C for 30 min to form the n-type solid-phase dopant source 24 of about 0. 2 µm in thickness, 160 µm in width, and 600 µm in pitch.

The n-type doping paste contained 5 wt% of silicon compound derived from tetraethoxysilane as a starting partial as the matrix material and 3 wt% of diphosphorus pentaoxide as the n-type dopant, and the solvent used included 30 wt% of a mixed solution of 70 wt% of isopropyl alcohol and ethyl acetate. The viscosity of the paste in an application environment at room temperature was 10 to 20 mPa·s.

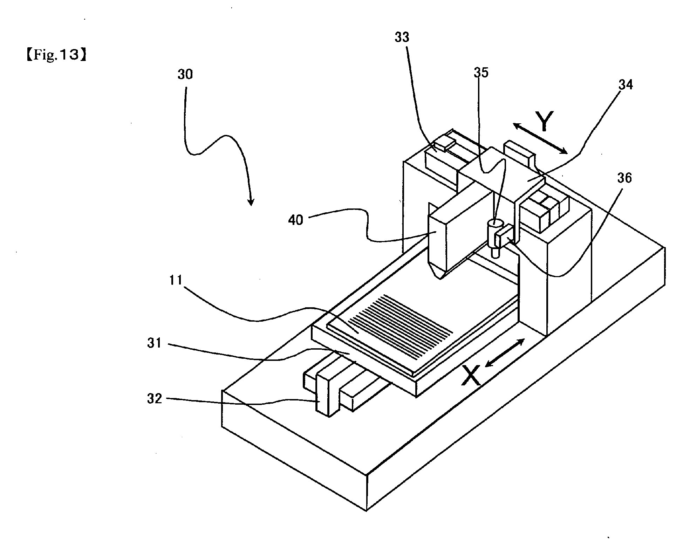

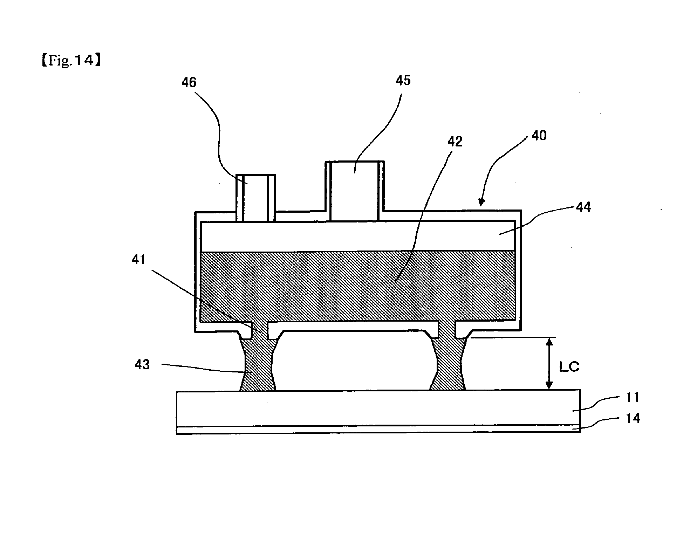

Fig. 13 shows a schematic diagram of a stripe coating applicator used in the present example. The n-type dopant was applied in a stripe shape by moving a nozzle 40 in the Y direction relative to the semiconductor substrate 11 vacuum-chucked to a stage 31. As shown in Fig. 14, the nozzle 40 was moved in a direction perpendicular to the paper surface while paste 42 was ejected from a plurality of ejecting orifices 41 formed in a power part of the nozzle 40 to form beads 43 between the semiconductor substrate 11 and the ejecting orifices 41. A clearance amount LC between the lower part of the ejecting orifices 41 and the semiconductor substrate 11 was adjusted to 20 to 300 µm.

Similarly, (c) a p-type doping paste was applied in a stripe shape and the p-type solid-phase dopant source 25 of about 0.2 µm in thickness, 360 µm in width, and 600 µm in pitch was formed by heating the p-type doping paste at 150°C for 30 min in the air and then at 500°C for 30 min.

The p-type doping paste contained 5 wt% of silicon compound derived from tetraethoxysilane as a starting partial as the matrix material and 3 wt% of boron oxide as the p-type dopant, and a mixed solution of 70 wt% of isopropyl alcohol (boiling point: 82°C) and 30 wt% of ethyl acetate (boiling point: 77°C) was used as a solvent. The viscosity of the paste in an application environment at room temperature was 10 to 20 mPa·s.

(d) By heating the semiconductor substrate 11 at 950°C for 60 min in nitrogen, the n-type dopant (phosphorus atoms) and the p-type dopant (boron atoms) contained in the n-type solid-phase dopant source 24 and the p-type solid-phase dopant source 25 were diffused into the semiconductor substrate 11 to form the n-type region 12 and the p-type region 13 respectively.

(e) The n-type solid-phase dopant source 24 and the p-type solid-phase dopant source 25 were removed by etching using fluoric acid.

Next, (f) the passivation layer 15 having the thickness of 0.2 µm and formed of silicon oxide was formed on the entire surface by dry oxidation of the back side of the semiconductor substrate 11.

Then, (g) an opening of 100 µm in width was formed by etching the passivation layer 15 by photolithography using fluoric acid.

Lastly, (h) the n-type contact electrode 16 and the p-type contact electrode 17 were formed by screen-printing and baking a silver paste at 500°C.

In this manner, the back-contact solar cell 10 shown in Figs. 1 and 2 was able to be manufactured by more simplified processes than forming solid-phase dopant sources using photolithography. However, because the boiling point of the solvent of the doping paste was relatively low, it was necessary to periodically remove a dry matter deposited at the nozzle tip in long-time stripe application. The measurement of the shape of the n-type region 12 and the p-type region 13 of the obtained back-contact solar cell 10 by removing the passivation layer 15, n-type contact electrode 16, and the p-type contact electrode 17 and mapping content of silicon, phosphorus and boron on the back side of the semiconductor substrate 11 by SIMS showed that the interval between the n-type region 12 and the p-type region 13 was within a desired value ±8 µm in any measured region. The withstand voltage when a reverse bias was applied to a pn junction was within a standard range.

### [Example 2]

The back-contact solar cell 10 was manufactured in the same manner as in Example 1 except that a mixed solution of 50 wt% of propylene glycol propyl ether (boiling point: 150°C), 35 wt% of isopropyl alcohol, and 15 wt% of ethyl acetate was used as the solvent of both doping pastes. The measurement of the shape of the n-type region 12 and the p-type region 13 in the same manner as in Example 1 showed that the interval between the n-type region 12 and the p-type region 13 was within a desired value ±8 µm in any measured region. The withstand voltage when a reverse bias was applied to a pn junction was also within the standard range and the back-contact solar cell 10 the same as in Example 1 was able to be manufactured. The amount of dry matter deposited at the nozzle tip was very small in long-time stripe application and the frequency of dry matter removal was significantly decreased when compared with Example 1.

### [Example 3]

The back-contact solar cell 10 was manufactured in the same manner as in Example 1 except that a mixed solution of 50 wt% of γBL (boiling point: 203°C), 35 wt% of isopropyl alcohol, and 15 wt% of ethyl acetate was used as the solvent of both doping pastes. The measurement of the shape of the n-type region 12 and the p-type region 13 in the same manner as in Example 1 showed that the interval between the n-type region 12 and the p-type region 13 was within a desired value ±8 µm in any measured region. The withstand voltage when a reverse bias was applied to a pn junction was also within the standard range and the back-contact solar cell 10 the same as in Example 1 was able to be manufactured. No dry matter was deposited at the nozzle tip in long-time stripe application.

### [Example 4]

The back-contact solar cell 10 was manufactured in the same manner as in Example 3 except that a mixed solution of 50 wt% of diethylene glycol monoethyl ether acetate (boiling point: 217°C), 35 wt% of isopropyl alcohol, and 15 wt% of ethyl acetate was used as the solvent of both doping pastes. The boiling point of the solvent component of the paste rose and it ended to spread in the horizontal direction without drying immediately after application and the width of the n-type solid-phase dopant source 24 spread to 260 µm. Thus, the back-contact solar cell 10 was able to be manufactured by adjusting the width of the p-type solid-phase dopant source 25 to 260 µm. The withstand voltage when a reverse bias was applied to a pn junction was also within the standard range. The measurement of the shape of the n-type region 12 and the p-type region 13 showed that the interval between the n-type region 12 and the p-type region 13 was within a desired value ±10 µm in any measured region.

### [Example 5 (Manufacturing method of forming a solid-phase dopant source without creating clearance)]

A back-contact solar cell was manufactured as described below based on the method shown in Fig. 7.

First, like Example 3, (a), the passivation layer 14 was formed on the light receiving side of the semiconductor substrate 11. Next, like Example 3, (b) the n-type solid-phase dopant source 24 of about 0.25 µm in thickness, 200 µm in width, and 600 µm in pitch was formed on the application surface (surface on the opposite side to the light receiving side) of the semiconductor substrate 11. Next, (c) a p-type doping paste was applied in a stripe shape. The p-type doping paste was applied without clearance by allowing the n-type solid-phase dopant source 25 after heating to function as a bank. By heating the p-type doping paste in the same manner as in Example 3, the p-type solid-phase dopant source 25 of about 0.25 µm in thickness, 400 µm in width, and 600 µm in pitch was formed.

(d) By heating the semiconductor substrate 11 at 950°C for 60 min in nitrogen containing oxygen (10%), the n-type dopant (phosphorus atoms) and the p-type dopant (boron atoms) each contained in the n-type solid-phase dopant source 24 and the p-type solid-phase dopant source 25 were diffused into the semiconductor substrate 11 to form the n-type region 12 and the p-type region 13 respectively.

Then, processes similar to the processes (e) to (h) in Example 3 were performed.

The withstand voltage when a reverse bias was applied to a pn junction of the obtained back-contact solar cell 10 was, like Example 3, within the standard range. The measurement of the shape of the n-type region 12 and the p-type region 13 showed that boundary lines of both match and the interval thereof was zero. However, both the n-type dopant and p-type dopant were diffused to form a region where the two deactivated one another so that an effect similar to the effect of forming the n-type region 12 and the p-type region 13 with space within the range of the desired value ±10 µm therebetween was a achieved.

### [Example 6 (Manufacturing method of forming a solid-phase dopant source after forming a passivation layer)]

A back-contact solar cell was manufactured as described below based on the method shown in Fig. 8.

First, the same semiconductor substrate 11 with that in Example 3 was prepared, (a) the passivation layer 14 was formed on the light receiving side of the semiconductor substrate 11 in the same manner as in Example 3, and the passivation layer 15 having the thickness of 0.3 µm and formed of silicon nitride was formed on the back side by the plasma CVD method. (b) An opening of 160 µm in width was formed in a portion corresponding to an n-type doped region formed later by etching the passivation layer 15 by photolithography using fluoric acid and an opening of 360 µm in width is formed in a portion corresponding to a p-type doped region.

Next, in the same manner as in Example 3, (c) the n-type solid-phase dopant source 24 of about 0.25 µm in thickness, 200 µm in width, and 600 µm in pitch was formed and (d) the p-type solid-phase dopant source 25 of about 0.25 µm in thickness, 400 µm in width, and 600 µm in pitch was formed.

(e) By heating the semiconductor substrate at 950°C for 60 min in nitrogen containing oxygen (10%), the n-type dopant (phosphorus atoms) and the p-type dopant (boron atoms) each contained in the n-type solid-phase dopant source 24 and the p-type solid-phase dopant source 25 were diffused into the semiconductor substrate 11 to form the n-type region 12 and the p-type region 13 respectively. With the passivation layer 15 functioning also as a diffusion mask, the n-type region 12 and the p-type region 13 was able to be formed with clearance therebetween with high precision.

(f) The n-type solid-phase dopant source 24 and the p-type solid-phase dopant source 25 were removed by etching using fluoric acid. Lastly, in the same manner as in Example 3, (g) the back-contact solar cell 10 was manufactured by forming the n-type contact electrode 16 and the p-type contact electrode 17.

The measurement of the shape of the n-type region 12 and the p-type region 13 in the same manner as in Example 3 showed that the interval between the n-type region 12 and the p-type region 13 was within a desired value ±5 µm. The withstand voltage when a reverse bias was applied to a pn junction in the obtained back-contact solar cell 10 was larger than the withstand voltage in Example 3, producing a satisfactory result.

### [Example 7 (Manufacturing method of patterning a solid-phase dopant source into a comb shape)]

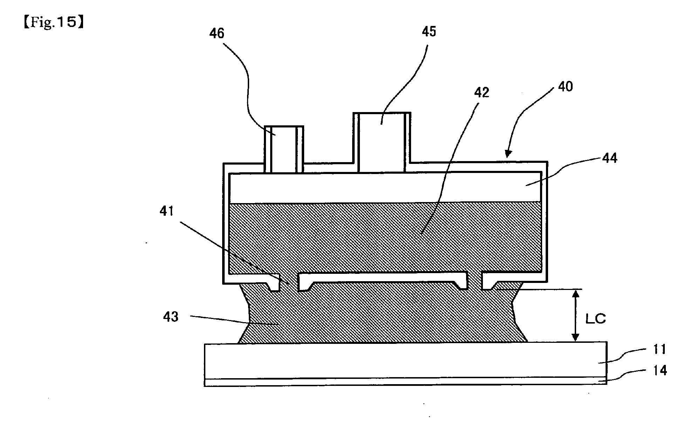

In an initial stage of applying an n-type doping paste and p-type doping paste, as shown in Fig. 15, beads 43 present between the semiconductor substrate 11 and the nozzle 40 and connected in the horizontal direction due to excessive paste were used. After the excessive paste was consumed by a series of application operations, as shown in Fig. 14, the stripe application was changed to a stripe application in which the beads 43 were separated for each of the ejecting orifices 41. Except that the n-type solid-phase dopant source 24 and the p-type solid-phase dopant source 25 in the comb shape shown in Fig. 9 were formed in this manner, the back-contact solar cell 10 was manufactured in the same manner as in Example 3. The measurement of the shape of the n-type region 12 and the p-type region 13 in the same manner as in Example 3 showed that the interval between the n-type region 12 and the p-type region 13 was within a range of a desired value ±8 µm in any measured region. The withstand voltage when a reverse bias was applied to a pn junction was also within the standard range and the back-contact solar cell 10 similar to one in Example 3 was able to be manufactured.

Because there was no need to control the amount of paste present between the semiconductor substrate 11 and the nozzle 40 immediately before the stripe application, the stripe application of paste was able to be realized more easily than in Example 3.

### [Example 8 (Manufacturing method of collectively applying n-type and p-type doping pastes)]

The back-contact solar cell 10 was manufactured in the same manner as in Example 3 except that the processes (b) to (d) were changed as described below.

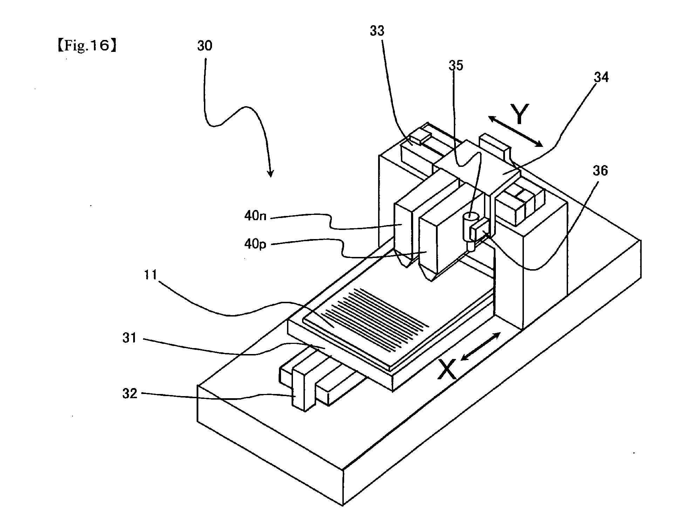

A stripe coating applicator 30 shown in Fig. 16 was used to collectively apply n-type and p-type doping pastes to the application surface of the semiconductor substrate 11. An n-type doping paste nozzle 40n and a p-type doping paste nozzle 40p were mutually aligned and arranged and the two nozzles 40n, 40p were integrally moved in the Y direction to collectively apply n-type and p-type doping pastes to the application surface of the semiconductor substrate 11.

Then, the n-type solid-phase dopant source 24 and the p-type solid-phase dopant source 25 similar to those in Example 3 were formed by heating the collectively applied semiconductor substrate 11 at 150°C for 30 min in the air and then at 500°C for 30 min. Subsequently, the n-type region 12 and the p-type region 13 were formed in the same manner as in Example 3 by heating the semiconductor substrate 11 at 950°C for 60 min in nitrogen.

The measurement of the shape of the n-type region 12 and the p-type region 13 by removing the passivation layer 15, n-type contact electrode 16, and the p-type contact electrode 17 and by mapping content of silicon, phosphorus and boron on the back side of the semiconductor substrate 11 by SIMS showed that the interval between the n-type region 12 and the p-type region 13 was within a desired value ±5 µm. The withstand voltage when a reverse bias was applied to a pn junction in the obtained back-contact solar cell 10 was in the standard range equivalent to the range in Example 5.

### [Comparative Example 1 (Manufacturing method by screen printing)]

The back-contact solar cell 10 was manufactured in the same manner as in Example 1 except that the n-type and p-type doping pastes used in Example 1 whose viscosity was adjusted was applied as a pattern by screen printing. The analysis of the shape of the n-type region 12 and the p-type region 13 in the same manner as in Example 1 showed that the interval between the n-type region 12 and the p-type region 13 exceeded a desired value ±10 µm. The withstand voltage when a reverse bias was applied to a pn junction was lower than in Example 3.

### [Comparative Example 2 (Manufacturing method of forming a solid-phase dopant source by photolithography)]

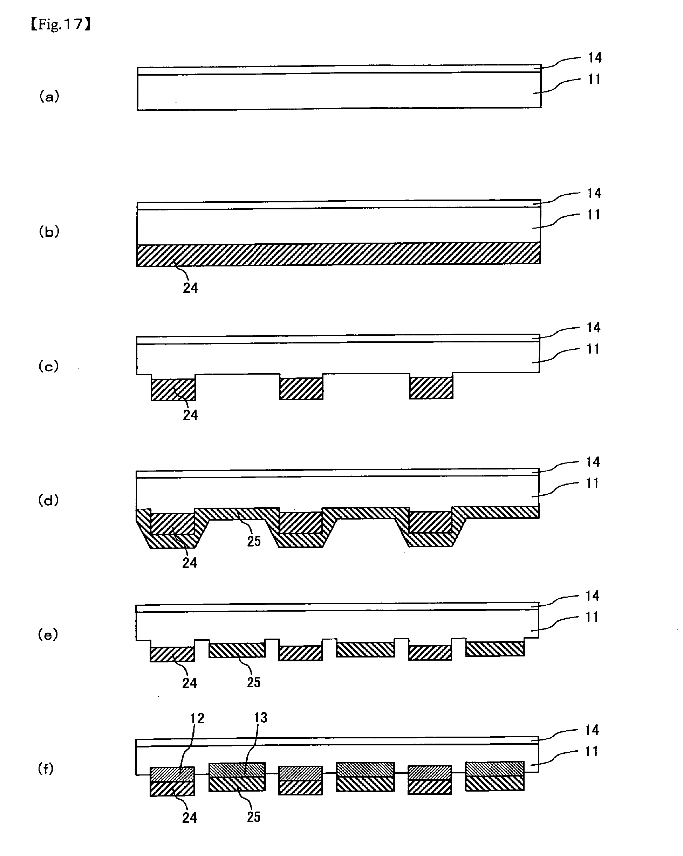

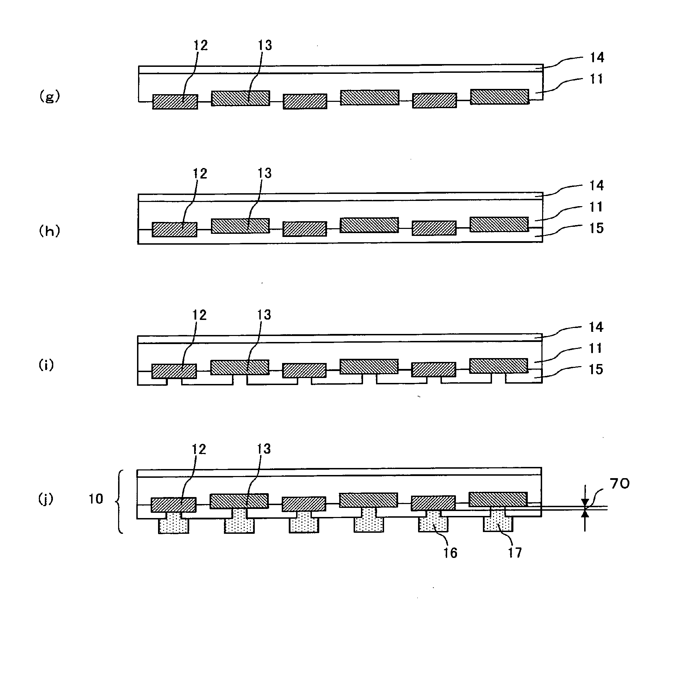

The back-contact solar cell 10 was manufactured by undergoing processes shown in Fig. 17. That is, first, like Example 1, (a) the passivation layer 14 was formed on the light receiving side of the semiconductor substrate 11. (b) The application surface of the semiconductor substrate 11 was spin-coated with the n-type doping paste used in Example 1 in which isopropyl alcohol was replaced by ethanol and heated at 150°C for 30 min in the air and further at 500°C for 30 min to form the n-type solid-phase dopant source 24 of about 0.3 µm in thickness on the entire surface thereof. (c) The n-type solid-phase dopant source 24 was patterned by photolithography to form the n-type solid-phase dopant source 24 of 160 µm in width and 600 µm in pitch. In this case, the back side of the semiconductor substrate 11 was etched by about 50 nm by fluoric acid used as an etchant, creating a step.

Next, (d) the application surface was spin-coated with the p-type doping paste used in Example 1 in which isopropyl alcohol was replaced by ethanol and heated at 150°C for 30 min in the air and further at 500°C for 30 min to form the p-type solid-phase dopant source 25 of about 0.2 µm in thickness on the entire surface thereof. (e) The p-type solid-phase dopant source 25 was patterned by photolithography to form the p-type solid-phase dopant source 25 of 360 µm in width and 600 µm in pitch. In this case, the thickness of the n-type solid-phase dopant source 24 formed previously was reduced to about 0.2 µm by fluoric acid used as an etchant and the back side of the semiconductor substrate 11 was etched by about 50 nm, further creating a step.

The back-contact solar cell 10 was manufactured by (f) to (j) in the same manner as (d) to (h) of Fig. 6 in Example 1. The analysis in the same manner as in Example 3 showed that the interval between the n-type region 24 and the p-type region 25 was within a range of desired value ±5 µm. However, a difference in height 70 arose between the surfaces of the n-type solid-phase dopant source 24 and the p-type solid-phase dopant source 25 and further a concave step was present between them.

### [Example 9 (Manufacturing method using a semiconductor substrate having irregularities on the back side thereof)]

A back-contact solar cell was manufactured as described below based on the method shown in Fig. 12.

First, the semiconductor substrate 11 formed of n-type single crystalline silicon having the thickness of 250 µm and the length of one side of 100 mm was prepared and both surfaces thereof were etched by about 20 µm by a heated sodium hydrate solution in order to remove slice damage and naturally-grown oxide. At this point, innumerable irregularities having a typical width of 40 to 100 µm and the depth of about 1 to 2 µm were formed on both surfaces of the semiconductor substrate 11.

Then, (a) the passivation layer 14 having the thickness of 0.3 µm and formed of silicon nitride was formed on the light receiving side of the silicon substrate 11 by the plasma CVD method.

On the other hand, (b) a masking paste was ejected from an ejecting orifice of a nozzle toward the back side of the semiconductor substrate 11 having irregularities to form beads formed of the masking paste between the semiconductor substrate 11 and the ejecting orifice and the masking paste was applied in a stripe shape by moving the semiconductor substrate 11 relative to the nozzle. Then, the semiconductor substrate 11 was heated at 150°C for 30 min in the air and further at 500°C for 30 min to form the diffusion mask 21 of about 1.0 µm in thickness, 440 µm in width, and 600 µm in pitch. In this case, the masking paste was likely to flow from a convex portion into a recess and thus, the width of the diffusion mask 21 tended to be wider in the recess than in the convex portion by about 5 µm. 40 wt% of phenylsilane silicon compound was used as the masking paste and methoxymethyl butanol (boiling point: 174°C) was used as the solvent. The viscosity of the paste was about 70 mPa·s.

Next, (c) the n-type doping paste used in Example 3 was applied in a stripe shape while allowing the diffusion mask 21 to function as a bank. Then, the n-type doping paste was baked at 200°C to form the n-type solid-phase dopant source 24 having the thickness of 0.4 µm without creating clearance to the diffusion mask 21. Therefore, the width of the n-type solid-phase dopant source 24 tended to be narrower in the recess than in the convex portion.

Then, (d) by heating the semiconductor substrate 11 at 950°C in the air, the n-type dopant (phosphorus atoms) contained in the n-type solid-phase dopant source 24 was diffused into the semiconductor substrate 11 in a solid phase to form the n-type region 12. Then, (e) the diffusion mask 21 and the n-type solid-phase dopant source 24 were removed by etching using fluoric acid.

(f) Next, in the same manner as in (b), the diffusion mask 21 of about 1.0 µm in thickness, 240 µm in width, and 600 µm in pitch was formed so as to cover the n-type region 12. In this case, the masking paste was likely to flow from a convex portion into a recess and thus, the width of the diffusion mask 21 tended to be wider in the recess than in the convex portion by about 5 µm.

(g) The p-type doping paste used in Example 3 was applied in a stripe shape while allowing the diffusion mask 21 to function as a bank. Then, the p-type doping paste was baked at 200°C to form the p-type solid-phase dopant source 24 having the thickness of 0.4 µm without creating clearance to the diffusion mask 21. Therefore, the width of the p-type solid-phase dopant source 25 tended to be narrower in the recess than in the convex portion.

(h) Then, in the same manner as in (d), the p-type dopant (boron atoms) contained in the p-type solid-phase dopant source 25 was diffused into the semiconductor substrate 11 in a solid phase to form the p-type region 13 and (i) the diffusion mask 21 and the p-type solid-phase dopant source 25 were removed by etching using fluoric acid.

Then, processes (j) to (1) were carried out similarly to the processes (f) to (h) in Example 3 to manufacture the back-contact solar cell 10.

The measurement of the shape of the n-type region 12 and the p-type region 13 of the back-contact solar cell 10 obtained as described above in the same manner as in Example 3 showed that the n-type region and p-type region had the widths of 160 µm and 360 µm respectively and the interval between both regions was within a range of a desired value ±10 µm in any measured region. The n-type region 12 and the p-type region 13 were superior in linearity of the longer side and the maximum protruding portion thereof was located within 16 µm from the reference line. Further, the maximum protruding portion was located in a position corresponding to a convex portion of the semiconductor substrate and the maximum value of intervals between the adjacent n-type region 12 and p-type region 13 in positions corresponding to recesses of the semiconductor substrate was larger than the minimum value of intervals therebetween in positions corresponding to convex portions of the semiconductor substrate. Thus, the interval between the n-type region 12 and the p-type region 13 tended to be larger than the design value, but since there was no region where the two came too close, generation efficiency and reliability were not affected. The withstand voltage when a reverse bias was applied to a pn junction was also within the standard range.

### [Comparative Example 3 (Manufacturing method of forming a solid-phase dopant source by photolithography on a semiconductor substrate having irregularities on the back side thereof)]

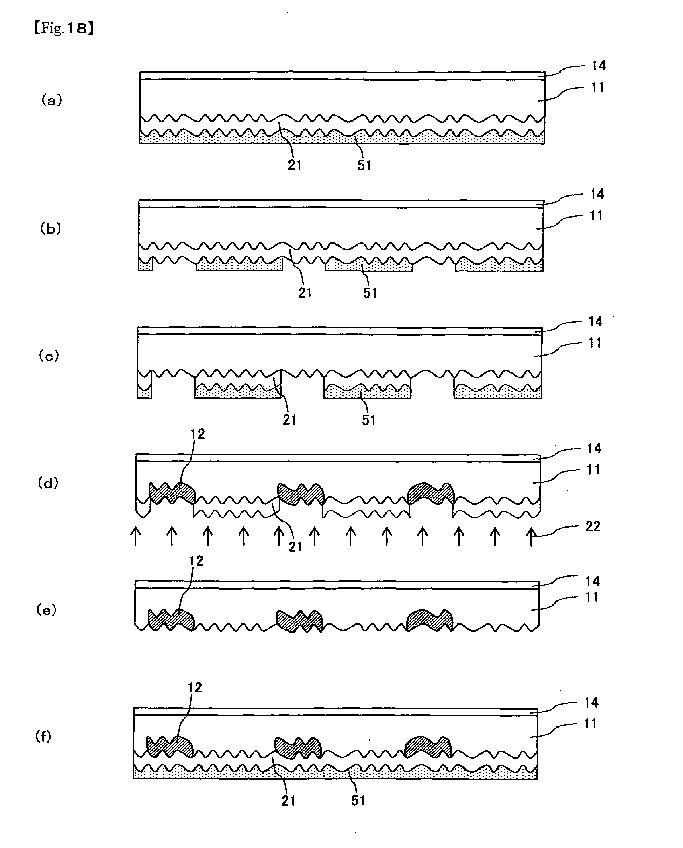

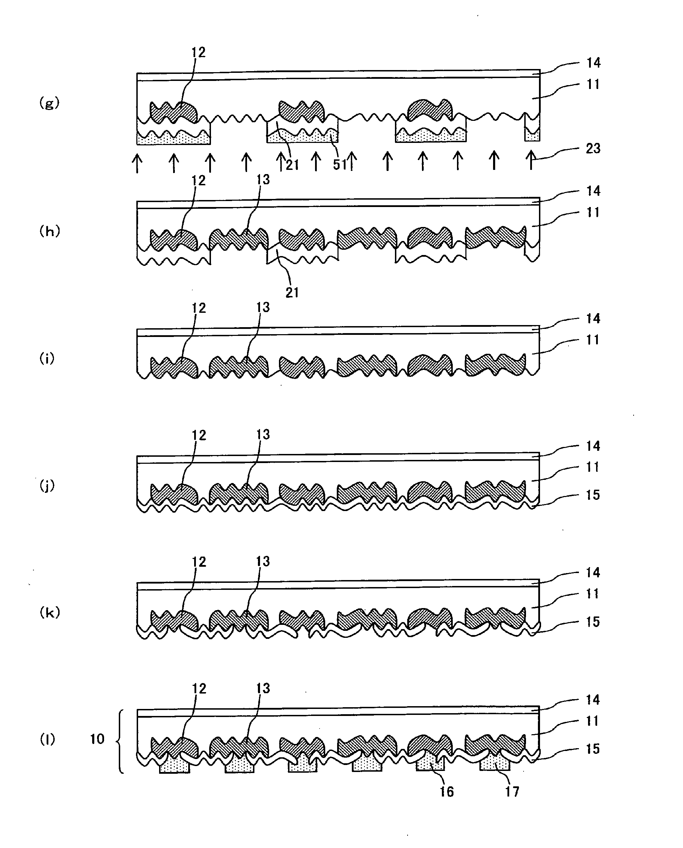

A back-contact solar cell was manufactured as described below based on the method shown in Fig. 18.

First, (a) after the passivation layer 14 was formed on the light receiving side of the semiconductor substrate 11 in the same manner as in Example 9, the diffusion mask 21 having the thickness of 0.5 µm and formed of silica was formed by the plasma CVD method and the negative type photoresist 51 having the thickness of 30 µm was formed thereon by the spin-coat method on the entire surface of the back side.

(b) The negative type photoresist 51 was patterned to the width of 440 µm and the pitch of 600 µm by photolithography. As described using Fig. 4, the angle of bottom reflection 53 of exposure changes according to irregularities and thus, unevenness of exposure of the negative type photoresist 51 arose and many portions of the longer side that exceeded 20 µm from the reference line were formed. Incidentally, the longer side of the negative type photoresist 51 was evaluated in the same method as the method used to analyze the longer side of a doped region.

(c) Unnecessary portions of the diffusion mask 21 were removed by etching using fluoric acid and (d) the negative type photoresist 51 was removed by an organic solvent and then, the n-type dopant (phosphorus atoms) 22 was diffused at 1000°C in a vapor phase to form the n-type region 12. Therefore, many portions on the longer side of the n-type region 12 where the maximum protruding portion exceeded 20 µm from the reference line were formed.

Then, (e) the diffusion mask 21 was removed by etching using fluoric acid.

(f) Next, in the same manner as in (a), the diffusion mask 21 having the thickness of 0. 5 µm and formed of silica was formed and the negative type photoresist 51 having the thickness of 30 µm was formed on the entire surface of the back side. Further, in the same manner as in (b), the negative type photoresist 51 was patterned to the width of 240 µm and the pitch of 600 µm. Like (b), many portions that exceeded 20 µm from the reference line were formed on the longer side of the negative type photoresist 51.

(g) Unnecessary portions of the diffusion mask 21 were removed by etching using fluoric acid and (h) the negative type photoresist 51 was removed by an organic solvent and then, the p-type dopant (boron atoms) 23 was diffused at 1000°C in a vapor phase to form the p-type region 13. Therefore, many portions on the longer side of the p-type region 13.where the maximum protruding portion exceeded 20 µm from the reference line were formed. Then, (i) the diffusion mask 21 was removed by etching using fluoric acid.

Then, processes (j) to (1) are performed in the same manner as in Example 9.

The measurement of the shape of the n-type region 12 and the p-type region 13 of the back-contact solar cell 10 obtained as described above in the same manner as in Example 3 showed that the n-type region and p-type region had the widths of 165 µm and 365 µm respectively and the measured regions where the interval therebetween exceeded the desired value ±15 µm were found. Moreover, many protruding portions were present in regions exceeding 17 µm from the reference line on the longer side of each of the n-type region 12 and the p-type region 13. Therefore, there were portions where the interval between the n-type region 12 and the p-type region 13 was extremely smaller than the design value particularly in positions corresponding to recesses of the semiconductor substrate and in addition, compared with the back-contact solar cell 10 in Example 9, the withstand voltage when a reverse bias was applied to a pn junction drops sharply. Therefore, the solar cell was a solar cell whose reliability was significantly lower.

### Industrial Applicability

The present invention can be used for the manufacture of a back-contact solar cell in which an n-type region and a p-type region and further corresponding contact electrodes are formed in a stripe shape on a back side of a semiconductor substrate.

### Reference Signs List

- 10: Back-contact solar cell
- 11: Semiconductor substrate
- 12: N-type region
- 13: P-type region
- 14: Passivation layer (Light receiving side)
- 15: Passivation layer (Back side)
- 16: N-type contact electrode
- 17: P-type contact electrode
- 21: Diffusion mask
- 22: N-type dopant
- 23: P-type dopant
- 24: N-type solid-phase dopant source
- 25: P-type solid-phase dopant source
- 30: Stripe coating applicator
- 31: Stage
- 32: Linear driving apparatus (X direction)
- 33: Linear driving apparatus (Y direction)
- 34: Bracket
- 35: CCD camera
- 36: Height sensor
- 40: Nozzle
- 41: Ejecting orifice
- 42: Paste
- 43: Bead
- 44: Manifold
- 45: Pressurization port
- 46: Paste supply port
- 51: Photoresist
- 52: Ultraviolet light (Exposure)
- 53: Bottom reflection
- 54: Bottom of the photoresist (Eroded portion)
- 55: Longer side (Reference line)
- 56: Maximum protruding portion
- 57: Photomask
- 70: Difference in height

## Claims

1. A method for manufacturing a semiconductor device, being **characterized in that** a p-type region and/or n-type pattern is formed on a surface of a semiconductor substrate, including a step of ejecting at least one of etching paste, masking paste, doping paste, and electrode paste from an ejecting orifice of a nozzle toward the surface of the semiconductor substrate to form beads formed of the paste between the semiconductor substrate and the ejecting orifice and of moving the semiconductor substrate relative to the nozzle thereby the paste is applied to the surface of the semiconductor substrate in a stripe shape.

2. The method for manufacturing a semiconductor device according to claim (1), wherein the semiconductor device is a back-contact solar cell having a pn junction formed on a side opposite to a light receiving side of the semiconductor substrate.

3. The method for manufacturing a semiconductor device according to claim (1) or (2), wherein half or more of solvent components contained in the paste by weight is a solvent whose boiling point is 150°C or higher and 210°C or lower.

4. The method for manufacturing a semiconductor device according to one of claims (1) to (3), wherein some paste of the etching paste, the masking paste, the doping paste, or the electrode paste is applied to the semiconductor substrate in the stripe shape and then, the other paste is applied to the semiconductor substrate in the stripe shape while the paste firstly applied remains on the semiconductor substrate.

5. The method for manufacturing a semiconductor device according to one of claims (1) to (3), wherein a solid-phase dopant source is patterned by heating the semiconductor substrate after one of n-type and p-type doping pastes is applied to the semiconductor substrate in the stripe shape, and the other doping paste is applied in the stripe shape by using the solid-phase dopant source as a bank.

6. The method for manufacturing a semiconductor device according to one of claims (1) to (5), wherein a patterned passivation layer is formed on a back side of the semiconductor substrate and the doping paste is applied to an opening of the passivation layer in the stripe shape.

7. The method for manufacturing a semiconductor device according to one of claims (1) to (6), wherein at least two of the etching paste, the masking paste, the doping paste, and the electrode paste are applied together.

8. The method for manufacturing a semiconductor device according to one of claims (1) to (6), wherein n-type and p-type doping pastes are applied together.

9. The method for manufacturing a semiconductor device according to one of claims (1) to (8), wherein the paste is applied to the surface of the semiconductor substrate in a comb shape by successively forming a connection portion in which the paste is connected in a horizontal direction and a stripe portion in which the paste is separated.

10. A back-contact solar cell, including a semiconductor substrate having irregularities in random shapes present at least on one surface, wherein n-type regions and p-type regions are formed in a stripe shape crossing the irregularities on the surface of the semiconductor substrate and longer sides of the n-type regions and the p-type regions are linear.

11. The back-contact solar cell according to claim (10), wherein a maximum protruding portion on the longer side of each of the n-type region and the p-type region is in a range within 20 µm from a reference line obtained by linear approximation by excluding 10% of points of measurement with great distances from a straight line obtained by approximation of the longer side of each of the longer sides based on the least square method.

12. The back-contact solar cell according to claim (10) or (11), wherein the maximum protruding portions of the longer side of each of the n-type region and the p-type region are located in a position corresponding to a convex portion of the semiconductor substrate.
